# EUROPEAN PATENT APPLICATION

(11) **EP 1 679 314 A1**
(43) Date of publication of application: **12.07.2006**
(21) Application number: 04792382.6
(22) Date of filing: 14.10.2004
(51) Int. Cl.: C07F 7/18, C08G 77/14, G03F 7/075, G03F 7/039, H01L 21/027

(54) **SILANE COMPOUND, POLYSILOXANE AND RADIATION-SENSITIVE RESIN COMPOSITION**

(30) Priority: 15.10.2003 JP 2003355112; 16.10.2003 JP 2003356898
(71) Applicant: JSR Corporation, Tokyo 104-8410 (JP)
(72) Inventor: NISHIMURA, Isao, c/o JSR Corp., Tokyo 104-8410 (JP); YAMAHARA, Noboru, c/o JSR Corp., Tokyo 104-8410 (JP); TANAKA, Masato, c/o JSR Corp., Tokyo 104-8410 (JP); SHIMOKAWA, Tsutomu, c/o JSR Corp., Tokyo 104-8410 (JP)
(74) Representative: TBK-Patent
(86) International application number: PCT/JP2004/015150
(87) International publication number: WO 2005/037846

(57) **Abstract**

A novel polysiloxane suitable as a resin component of a chemically-amplified resist exhibiting particularly excellent I-D bias, depth of focus (DOF), and the like, a novel silane compound useful as a raw material for synthesizing the polysiloxane, and a radiation-sensitive resin composition comprising the polysiloxane are provided.

The silane compound is shown by the following formula (I), 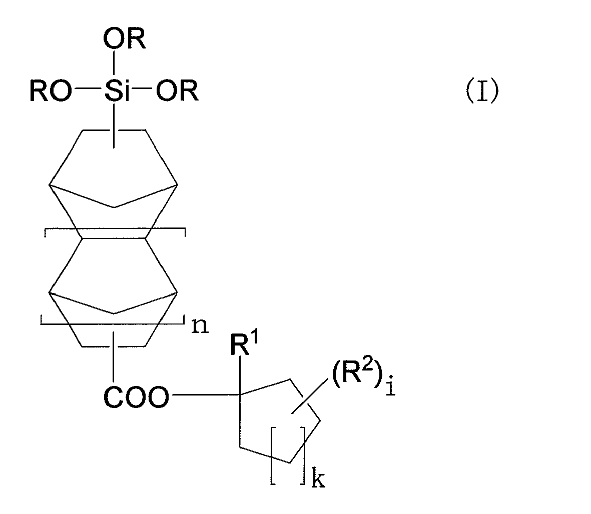 and the polysiloxane has a structural unit shown by the following formula (1), 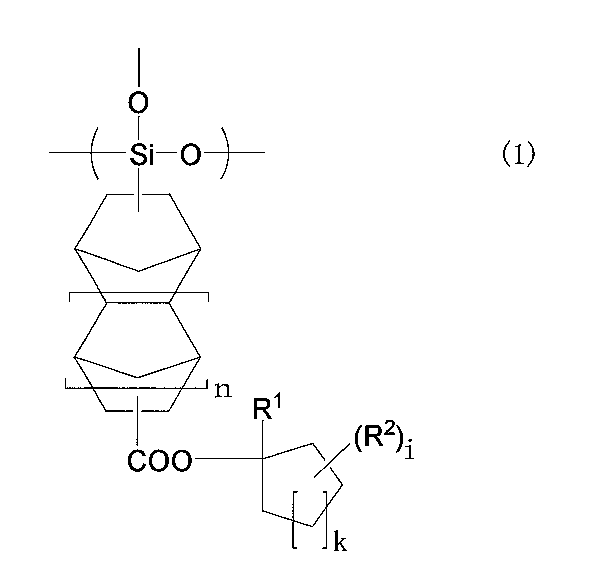 wherein R is an alkyl group, R¹ and R² individually represent a fluorine atom, lower alkyl group, or lower fluoroalkyl group, n is 0 or 1, k is 1 or 2, and i is an integer of 0 to 10.

The radiation-sensitive resin composition comprises the polysiloxane and a photoacid generator.

## Description

### TECHNICAL FIELD

The present invention relates to a novel silane compound, a novel polysiloxane, and a radiation-sensitive resin composition comprising the polysiloxane suitable for microprocessing using radiation such as deep ultraviolet radiation, electron beams, and X-rays.

### BACKGROUND ART

A recent strong demand for high density and highly integrated LSIs (large-scale integrated circuits) radically accelerates miniaturization of wiring patterns.

Using short wavelength rays in a lithographic process is one method for miniaturizing wiring patterns. In recent years, deep ultraviolet rays typified by a KrF excimer laser (wavelength: 248 nm), an ArF excimer laser (wavelength: 193 nm), or an F₂ excimer laser (wavelength: 157 nm), electron beams, X-rays, and the like are being used in place of ultraviolet rays such as g-line (wavelength: 436 nm), and i-line (wavelength: 365 nm).

Novolac resins, poly(vinylphenol) resins, and the like have been conventionally used in resist compositions. However, because these resins exhibit strong absorbance at a wavelength of 193 nm due to inclusion of aromatic rings in the structure, a lithographic process by an ArF excimer laser, for example, using these resins cannot provide high accuracy corresponding to high photosensitivity, high resolution, and a high aspect ratio.

Therefore, a resin for use in a resist, transparent to a wavelength of 193 nm or less, particularly to an ArF excimer laser (wavelength: 193 nm) or an F₂ excimer laser (wavelength: 157 nm), and exhibiting the same or higher dry etching resistance as the resist composition containing aromatic rings, has been desired. A polysiloxane is one such a polymer. R. R. Kunz et al. of the MIT have reported their research results showing excellent transparency of a polysiloxane at a wavelength of 193 nm or less, particularly at 157 nm, commenting on superiority of this polymer as a resist in a lithographic process using radiation with a wavelength of 193 nm or less (see, for example, J. Photopolym. Sci. Technol., Vol. 12, No. 4 (1999), P. 561-570; SPIE, Vol. 3678 (1999) P. 13-23). Moreover, polysiloxanes are known to exhibit excellent dry etching resistance. In particular, a resist containing polyorganosilsesquioxane having a ladder structure is known to possess high plasma resistance.

Several chemically-amplified resist compositions using a siloxane polymer have also been reported. A radiation-sensitive resin composition comprising a polysiloxane having an acid-dissociable group such as a carboxylic acid ester group, phenol ether group, etc., on the side chain, bonded to a silicon atom via one or more carbon atoms has been disclosed (e.g. Japanese Patent Application Laid-open No. 323611/1993). However, this polysiloxane cannot provide high resolution if the acid-dissociable carboxylic acid groups on the side chain do not efficiently dissociate. If a large number of acid-dissociable groups dissociate, on the other hand, the curing shrinkage stress of the resist film increases, causing cracks and peels in the resist film.

A positive tone resist using a polymer in which the carboxyl group of poly(2-carboxyethylsiloxane) is protected with an acid-dissociable group such as a t-butyl group has also been disclosed (Japanese Patent Application Laid-open No. 160623/1996). Since this resist protects the carboxyl groups only insufficiently, it is difficult to develop the resist containing a large amount of carboxylic acid components remaining in the non-exposed area using a common alkaline developing solution.

A resist resin composition containing a polyorganosilsesquioxane having an acid-dissociable ester group has also been disclosed (e.g. Japanese Patent Application Laid-open No. 60733/1999). This polyorganosilsesquioxane is prepared by the addition reaction of an acid-dissociable group-containing (meth)acryl monomer to a condensation product of vinyltrialkoxysilane, γ-methacryloxypropyltrialkoxysilane, or the like. The resin has a problem of insufficient transparency to light with a wavelength of 193 nm or less due to unsaturated groups originating from a (meth) acrylic monomer remaining on the polymer side chains. The patent specification also describes a resist resin composition containing a polymer made by the esterification of polyhydroxycarbonylethylsilsesquioxane with t-butyl alcohol. This polymer also has the same problem as a resist as encountered by the polymer disclosed in Japanese Patent Application Laid-open No. 160623/1996 due to a low degree of carboxyl group protection.

Moreover, a chemically-amplified resist using a siloxane polymer of the type mentioned above is demanded to release acid dissociable group contained therein at a comparatively low temperature, making it possible to decrease the heating temperature after exposure to radiation and, as a result, to appropriately control diffusion of acid generated by exposure, thereby enabling the resist to exhibit excellent I-D bias, which is the characteristics of inhibiting a line width fluctuation in line patterns according to the pattern density when a line-and-space pattern is formed.

More recently, Japanese Patent Application Laid-open No. 2002-268225 discloses a polymer compound having a cyclic organic group substituted with a carboxylic acid ester group esterified by an acid-instable group (such as a t-butyl group, 1-methylcyclohexyl group, 1-ethylcyclopentyl group, etc.) and a fluorine atom or fluoroalkyl group, and a siloxane-type recurring unit of which the silicon atom bonds to the cyclic organic group, more specifically, a polycondensate of 2-t-butoxycarbonyl-2-trifluoromethyl-5(6)-trichlorosilylnorbornane and 2-hydroxy-2-trifluoromethyl-5(6)-trichlorosilylnorbornane, a polycondensate of 2-t-butoxycarbonyl-2-trifluoromethyl-5(6)-trichlorosilylnorbornane and 2-[2-hydroxy-2,2-di(trifluoromethyl)ethyl]-5(6)-trichlorosilylnorbornane, and the like, and a chemically-amplified resist containing these polymer compounds. The specification claims that the chemically-amplified resist excels in sensitivity, resolution, and plasma etching resistance.

On the other hand, along with recent progress of miniaturization of resist patterns, a process margin such as I-D bias and depth of focus (DOF) is being highlighted as important properties of chemically-amplified resists, including the case in which the chemically-amplified resist contains a siloxane polymer. A chemically-amplified resist with excellent property balance including such a process margin is strongly desired.

### DISCLOSURE OF THE INVENTION

An object of the present invention is to provide a novel polysiloxane suitable as a resin component for a radiation-sensitive resin composition which is suitable for use particularly as a chemically-amplified resist exhibiting high transparency at a wavelength of 193 nm or less and possesses an excellent property balance, including process allowance of I-D bias, depth of focus (DOF), and the like.

Another object of the present invention is to provide a radiation-sensitive resin composition useful as a chemically-amplified resist containing the polysiloxane and possessing an excellent property balance, including the above process allowance.

Still another object of the present invention is to provide a novel silane compound which is useful as a raw material for synthesizing the above polysiloxane and the like.

Other objects, features, and advantages of the invention will hereinafter become more readily apparent from the following description.

First, the present invention provides a siliane compound of the following formula (I) (hereinafter referred to as "silane compound (I)"), 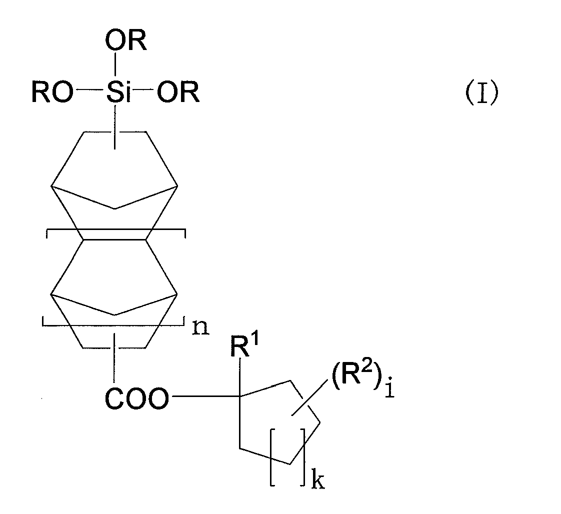 wherein R individually represents a linear, branched, or cyclic alkyl group having 1 to 20 carbon atoms, R¹ and R² individually represents a fluorine atom, a linear or branched alkyl group having 1 to 4 carbon atoms, or a linear or branched fluoroalkyl group having 1 to 4 carbon atoms, n is 0 or 1, k is 1 or 2, and i is an integer of 0 to 8 when k = 1 and an integer of 0 to 10 when k = 2.

In the formula (I), when n = 0, the silicon atom bonds to 2- or 3-position of the norbornane ring and the carbon atom of the -COO- group bonds to 5- or 6-position of the norbornane ring, and when n = 1, the silicon atom bonds to 4- or 5-position of the tetracyclododecane ring and the carbon atom of the -COO- group bonds to 9- or 10-position of the tetracyclododecane ring.

Secondly, the present invention provides a polysiloxane having a structural unit of the following formula (1) and a polystyrene-reduced weight average molecular weight determined by gel permeation chromatography (GPC) of 500 to 1,000,000 (hereinafter referred to as "polysiloxane (1)"), 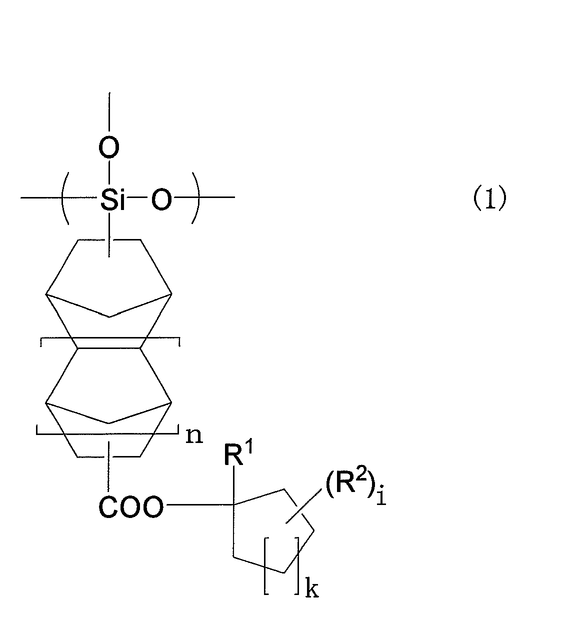 wherein R¹ and R² individually represents a fluorine atom, a linear or branched alkyl group having 1 to 4 carbon atoms, or a linear or branched fluoroalkyl group having 1 to 4 carbon atoms, n is 0 or 1, k is 1 or 2, and i is an integer of 0 to 8 when k = 1 and an integer of 0 to 10 when k = 2.

In the formula (1), when n = 0, the silicon atom bonds to 2- or 3-position of the norbornane ring and the carbon atom of the -COO- group bonds to 5- or 6-position of the norbornane ring, and when n = 1, the silicon atom bonds to 4- or 5-position of the tetracyclododecane ring and the carbon atom of the -COO- group bonds to 9- or 10-position of the tetracyclododecane ring.

Thirdly, the present invention provides a radiation-sensitive resin composition comprising (A) the polysiloxane (1) and (B) a photoacid generator.

The present invention is described below in detail.

### Silane compound (I)

As the linear, branched, or cyclic alkyl group having 1 to 20 carbon atoms represented by R in the formula (I), a methyl group, ethyl group, n-propyl group, i-propyl group, n-butyl group, 2-methylpropyl group, 1-methylpropyl group, t-butyl group, n-pentyl group, n-hexyl group, n-heptyl group, n-octyl group, n-nonyl group, n-decyl group, n-dodecyl group, n-tetradecyl group, n-hexadecyl group, n-octadecyl group, eicosyl group, cyclopentyl group, cyclohexyl group, and the like can be given.

Of these alkyl groups, a methyl group, ethyl group, and the like are preferable.

As examples of the linear or branched alkyl group having 1-4 carbon atoms represented by R¹ and R² in the formula (I), a methyl group, ethyl group, n-propyl group, i-propyl group, n-butyl group, 2-methylpropyl group, 1-methylpropyl group, and t-butyl group can be given.

Of these alkyl groups, a methyl group, ethyl group, and the like are preferable.

As examples of the linear or branched fluoroalkyl group having 1 to 4 carbon atoms represented by R¹ and R², a fluoromethyl group, trifluoromethyl group, 2,2,2-trifluoroethyl group, pentafluoroethyl group, 3,3,3-trifluoro-n-propyl group, 3,3,3,2,2-pentafluoro-n-propyl group, heptafluoro-n-propyl group, 4,4,4-trifluoro-n-butyl group, 4,4,4,3,3-pentafluoro-n-butyl group, 4,4,4,3,3,2,2-heptafluoro-n-butyl group, and nonafluoro-n-butyl group can be given.

Of these fluoroalkyl groups, a trifluoromethyl group, 2,2,2-trifluoroethyl group, pentafluoroethyl group, and the like are preferable.

As R¹ and R² in the formula (I), a fluorine atom, methyl group, ethyl group, trifluoromethyl group, 2,2,2-trifluoroethyl group, pentafluoroethyl group, and the like are particularly preferable.

As n, both 0 and 1 are preferable, as m, both 1 and 2 are preferable, and as i, 0 to 2 are preferable.

As preferable examples of the silane compound (I), compounds shown by the following formulas (I-1-1) to (I-1-4), compounds shown by the following formulas (I-2-1) to (I-2-4), and the like can be given.

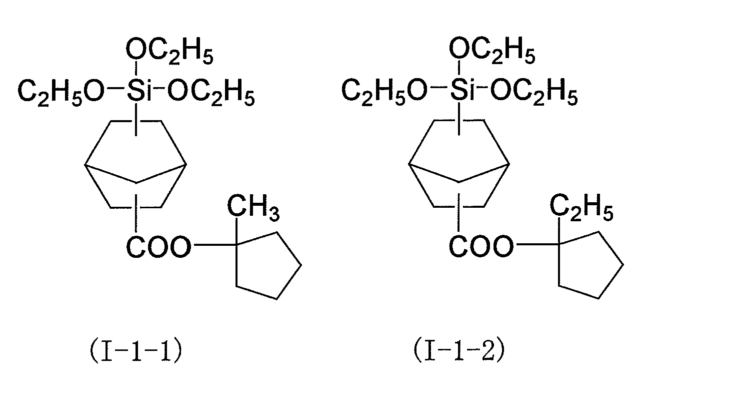

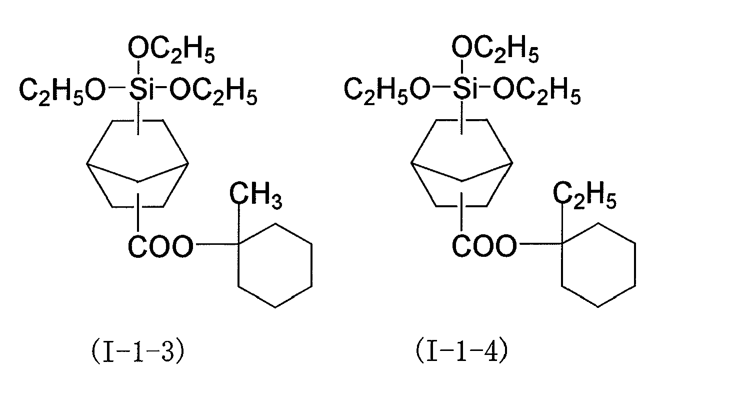

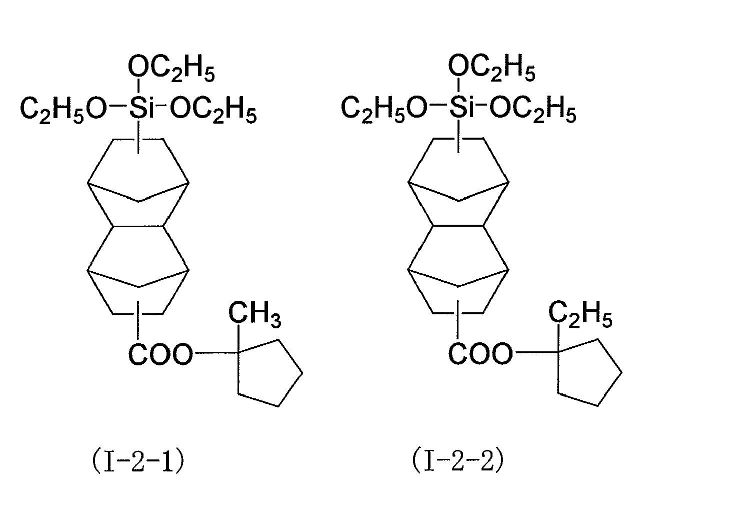

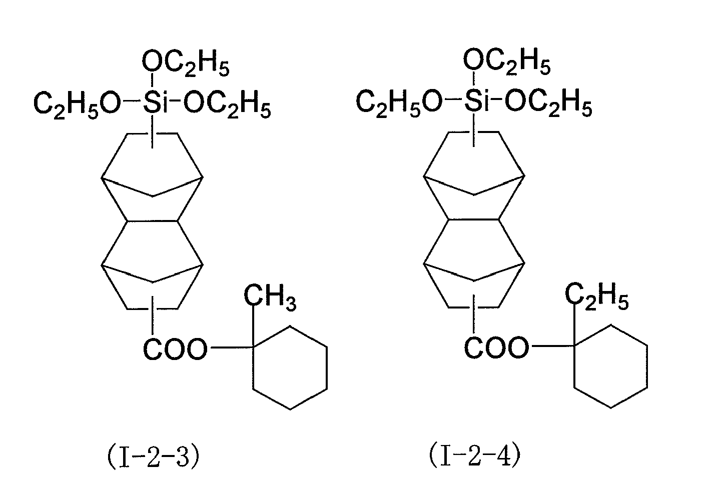

The silane compound (I) can be synthesized by, for example, as described later in Synthesis Example 1, an addition reaction of triethoxysilane and a derivative corresponding to bicyclo[2.2.1]hept-2-ene or a derivative corresponding to tetracyclo[4.4.0.1^{2,5}.1^{7,10}]dodec-3-ene in the presence of chloroplatinic acid (H₂PtCl₆).

The silane compound (I) can be used very suitably not only as a raw material for synthesizing polysiloxane (1) and polysiloxane (1-1), but also as a raw material or intermediate material for synthesizing other related silane compounds and other polysiloxanes.

### Polysiloxane (1)

The polysiloxane (1) is a siloxane polymer having the structural unit shown by the above formula (1) (hereinafter referred to as "structural unit (1)").

The structure of the carboxylic acid ester in the formula (1) forms an acid-dissociable group which dissociates in the presence of an acid and produces a carboxyl group.

As examples of the linear or branched alkyl group having 1 to 4 carbon atoms or linear or branched fluoroalkyl group having 1 to 4 carbon atoms represented by R¹ and R² in the formula (1), the same groups given for the linear or branched alkyl group having 1 to 4 carbon atoms or linear or branched fluoroalkyl group having 1 to 4 carbon atoms represented by R¹ and R² in the formula (I) can be mentioned.

In the structural unit (1), a methyl group, ethyl group, propyl group, butyl group, and the like are preferable as R¹, a fluorine atom, methyl group, ethyl group, trifluoromethyl group, 2,2,2-trifluoroethyl group, pentafluoroethyl group, and the like are preferable as R², both 1 and 2 are preferable as k, and 0 is particularly preferable as i.

The structural unit (1) is a unit in which the silane compound (I) condensed at positions of three -OR groups which are bonded to the silicon atoms. As preferable examples, units obtainable by condensation of the compounds shown by the above formulas (I-1-1) to (I-1-4) or the compounds shown by the above formulas (I-2-1) to (I-2-4), which are described as preferable examples of the silane compound (I), and the like can be given.

The structural unit (1) may be present in the polysiloxane (1) either individually or in combination of two or more.

The polysiloxane (1) may contain one or more structural units other than the structural unit (1) (such other structural units are hereinafter referred to as "other structural units (α)".

As examples of the other structural unit (α), in addition to the structural units derived from a trifunctional or tetrafunctional silane compound in respect of a condensation reaction, such as the structural units of the following formulas (3), (4), or (5), the structural units derived from a difunctional silane compound in respect of a condensation reaction can be given, 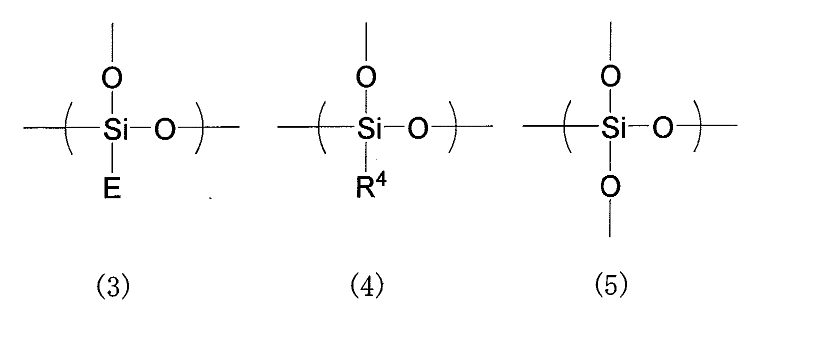 wherein E is a monovalent organic group having a fluorohydrocarbon group and R⁴ represents a linear, branched, cyclic, or polycyclic alkyl group having 1 to 20 carbon atoms, a linear or branched halogenated alkyl group having 1 to 20 carbon atoms, a monovalent aromatic hydrocarbon group having 6 to 20 carbon atoms, or a monovalent halogenated aromatic hydrocarbon group having 6 to 20 carbon atoms.

As examples of the monovalent organic group having a fluorohydrocarbon group represented by E in the formula (3), groups of the following formulas (6) or (7) can be given,

―Y―OZ (6)

―Y―CF₂―OZ (7)

wherein Y individually represents a substituted or unsubstituted divalent hydrocarbon group having a cyclic structure with 4 to 20 carbon atoms and Z individually represents a hydrogen atom, a monovalent hydrocarbon group having 1 to 10 carbon atoms, or a monovalent halogenated hydrocarbon group having 1 to 10 carbon atoms, provided that either Y or Z in the formula (6) is a group having a fluorine atom.

As examples of the divalent hydrocarbon group having a cyclic structure with 4 to 20 carbon atoms and its substitution derivatives represented by Y in the formulas (6) and (7), groups having a cycloalkane skeleton such as a 1,3-cyclobutylene group, 1,3-cyclopentylene group, 1,3-cyclohexylene group, 1,4-cyclohexylene group, 1-trifluoromethyl-1,3-cyclohexylene group, 1-trifluoromethyl-1,4-cyclohexylene group, and a group shown by the following formula (Y-1), 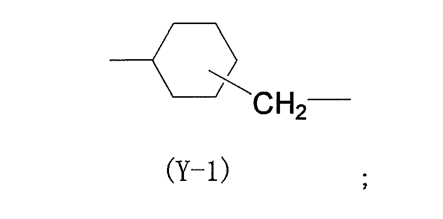 groups having an aromatic skeleton such as a 1,4-phenylene group, perfluoro-1,4-phenylene group, 1,4-naphthylene group, 2,3-naphthylene group, perfluoro-1,4-naphthylene group, perfluoro-2,3-naphthylene group, groups shown by the following formulas (Y-2) or (Y-3), 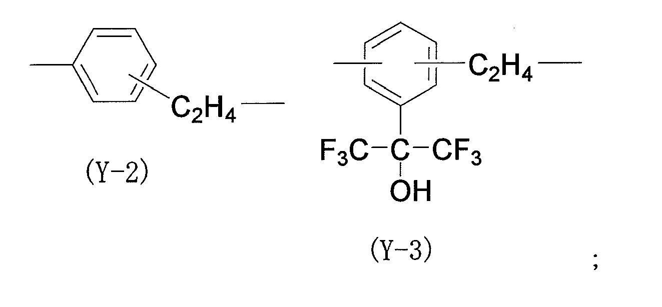 groups having a bridged alicyclic skeleton such as the groups shown by the following formulas (Y-4) to (Y-19), 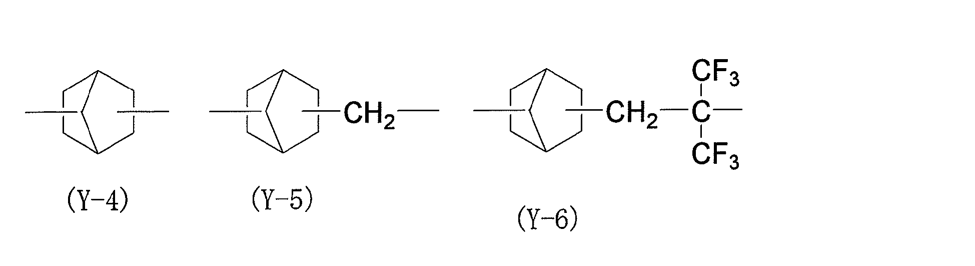 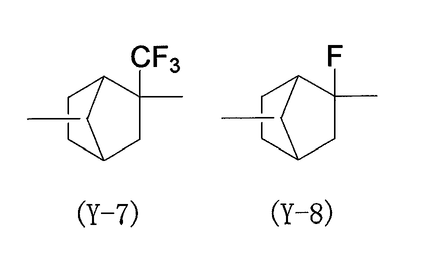 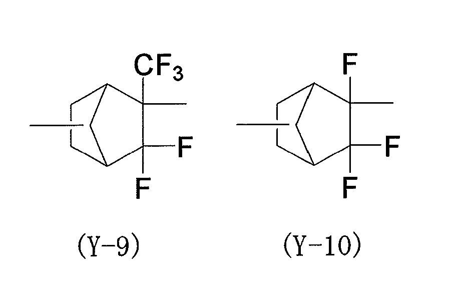 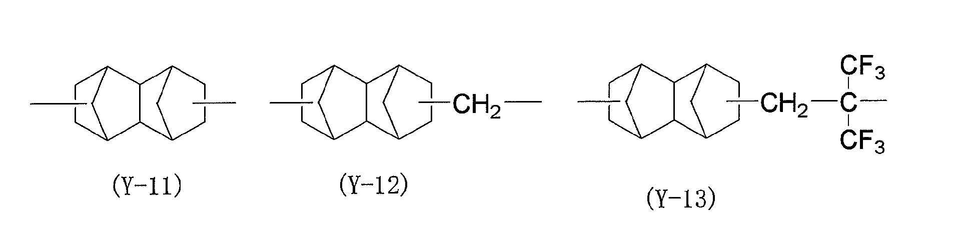 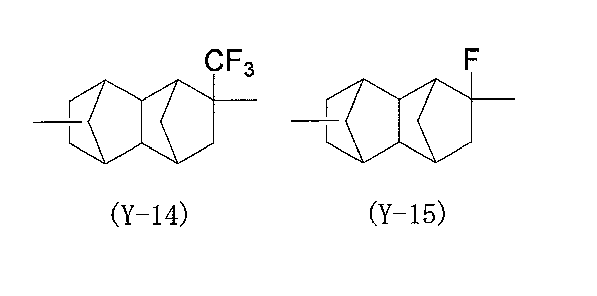 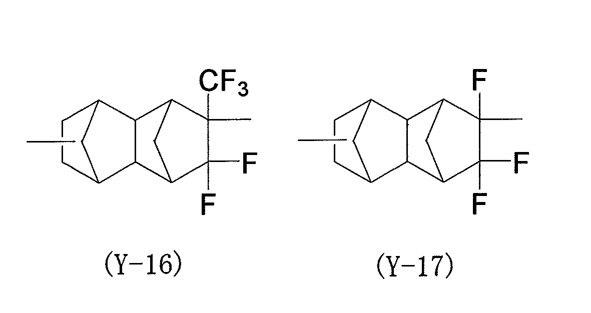 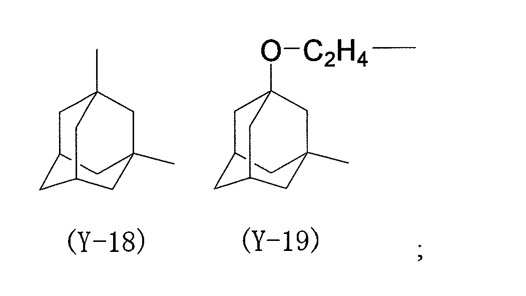 and the like can be given.

In the above groups having a cycloalkane skeleton, an aromatic skeleton, or a bridged alicyclic skeleton, it is desirable that the cycloalkane skeleton, aromatic skeleton, and bridged alicyclic skeleton directly bond to the silicon atom in the formula (2).

As Y in the formulas (6) and (7), groups having a norbornane skeleton or a tetracyclododecane skeleton are preferable, with the groups substituted with a fluorine atom or a trifluoromethyl group being more preferable. Particularly preferable groups are those represented by the formulas (Y-4), (Y-6), (Y-9), or (Y-10).

As the examples of the monovalent hydrocarbon group having 1 to 10 carbon atoms represented by Z, linear, branched, or cyclic alkyl groups such as a methyl group, ethyl group, n-propyl group, i-propyl group, n-butyl group, 2-methylpropyl group, 1-methylpropyl group, t-butyl group, n-pentyl group, 3-methylbutyl group, neopentyl group, n-hexyl group, n-heptyl group, n-octyl group, 2-ethylhexyl group, n-nonyl group, n-decyl group, cyclobutyl group, cyclopentyl group, and cyclohexyl group; aromatic hydrocarbon groups such as a phenyl group, o-tolyl group, m-tolyl group, p-tolyl group, benzyl group, phenethyl group, α-naphthyl group, and β-naphthyl group; and bridged hydrocarbon groups such as a norbornyl group, tricyclodecanyl group, tetracyclodecanyl group, and adamantyl group can be given.

Of these monovalent hydrocarbon groups, a methyl group, ethyl group, n-propyl group, n-butyl group, and the like are preferable.

As examples of the monovalent halogenated hydrocarbon groups having 1 to 10 carbon atoms represented by Z, the aforementioned monovalent hydrocarbon groups having 1 to 10 carbon atoms substituted with one or more halogen atoms such as a fluorine atom, chlorine atom, and bromine atom, preferably with one or more fluorine atoms (hereinafter referred to as "monovalent fluorohydrocarbon group"), can be given. As specific examples, a trifluoromethyl group, 2,2,2-trifluoroethyl group, pentafluoroethyl group, 3,3,3-trifluoro-n-propyl group, 3,3,3,2,2-pentafluoro-n-propyl group, heptafluoro-n-propyl group, 4,4,4-trifluoro-n-butyl group, 4,4,4,3,3-pentafluoro-n-butyl group, 4,4,4,3,3,2,2-heptafluoro-n-butyl group, nonafluoro-n-butyl group, 5,5,5-trifluoro-n-pentyl group, 5,5,5,4,4-pentafluoro-n-pentyl group, 5,5,5,4,4,3,3-heptafluoro-n-pentyl group, 5,5,5,4,4,3,3,2,2-nonafluoro-n-pentyl group, perfluoro-n-pentyl group, and perfluoro-n-octyl group can be given.

Of these monovalent fluorohydrocarbon groups, a trifluoromethyl group, 2,2,2-trifluoroethyl-group, pentafluoroethyl group, 3,3,3-trifluoro-n-propyl group, 3,3,3,2,2-pentafluoro-n-propyl group, heptafluoro-n-propyl group, nonafluoro-n-butyl group, perfluoro-n-pentyl group, and the like are preferable.

As Z in the formulas (6) and (7), a hydrogen atom, heptafluoro-n-propyl group, and the like are particularly preferable.

In the formula (4), as examples of the linear or branched alkyl group having 1 to 20 carbon atoms represented by R⁴, a methyl group, ethyl group, n-propyl group, i-propyl group, n-butyl group, 2-methylpropyl group, 1-methylpropyl group, t-butyl group, n-pentyl group, n-hexyl group, n-heptyl group, n-octyl group, n-nonyl group, and n-decyl group can be given; as examples of the linear or branched halogenated alkyl group having 1 to 20 carbon atoms, a trifluoromethyl group, pentafluoroethyl group, heptafluoro-n-propyl group, and heptafluoro-i-propyl group can be given; as examples of the monovalent aromatic hydrocarbon group having 6 to 20 carbon atoms, a phenyl group, α-naphthyl group, β-naphthyl group, benzyl group, and phenethyl group can be given; and as examples of the monovalent halogenated aromatic hydrocarbon group having 6 to 20 carbon atoms, a pentafluorophenyl group, perfluorobenzyl group, perfluorophenethyl group, 2-(pentafluorophenyl)hexafluoro-n-propyl group, and 3-(pentafluorophenyl)hexafluoro-n-propyl group can be given.

As R⁴ in the structural unit (4), a methyl group, ethyl group, trifluoromethyl group, pentafluoroethyl group, perfluorophenethyl group, 3-(perfluorophenyl)hexafluoro-n-propyl group, and the like are preferable.

In the polysiloxane (1), the content of the structural unit (1) is usually 10 to 100 mol%, preferably 15 to 90 mol%, and still more preferably 20 to 70 mol%. If the content of the structural unit (1) is less than 10 mol%, resolution tends to decrease due to insufficient dissolution contrast.

The content of the other structural units (α) is usually 5 mol% or more, preferably 10 to 80 mol%, and more preferably 20 to 80 mol%. If the content of the other structural units (α) is less than 5 mol%, I-D bias tends to decrease.

The polystyrene-reduced weight average molecular weight of the polysiloxane (1) determined by gel permeation chromatography (GPC) (hereinafter referred to as "Mw") is 500 to 1,000,000, preferably 500 to 100,000, and particularly preferably 500 to 40,000. If the Mw is less than 500, the glass transition temperature of the resulting polymer (Tg) tends to decrease. If the Mw exceeds 1,000,000, on the other hand, solubility of the resulting polymer in solvents tends to decrease.

The polysiloxane (1) has high transparency to radiation with a wavelength of 193 nm or less, exhibits superior dry etching resistance, and is particularly excellent in I-D bias. The resin composition is very useful not only as a resin component in a chemically-amplified resist for microprocessing using radiation such as deep ultraviolet radiation, electron beams, and X-rays, but also for formed articles, films, laminate materials, paints, and the like by itself or as a mixture with various other polysiloxanes.

### Polysiloxane (1-1)

As the polysiloxane (1), a polysiloxane (hereinafter referred to as "polysiloxane (1-1)") having the structural unit shown by the above structural unit (1) and a structural unit shown by the following formula (2) (excluding the structural unit (1)) (hereinafter referred to as "structural unit (2)") is also preferable, 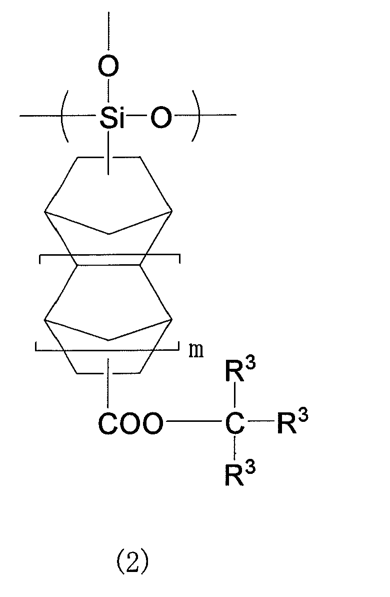 wherein R³ individually represents a linear or branched alkyl group having 1 to 4 carbon atoms or a monovalent alicyclic hydrocarbon group having 4 to 20 carbon atoms or a derivative thereof, or any two of R³s form in combination a divalent alicyclic hydrocarbon group having 4 to 20 carbon atoms or a derivative thereof, with the remaining R³ being a linear or branched alkyl group having 1 to 4 carbon atoms or a monovalent alicyclic hydrocarbon group having 4 to 20 carbon atoms or a derivative thereof, and m is 0 or 1.

In the formula (2), when m = 0, the silicon atom bonds to 2- or 3-position of the norbornane ring and the carbon atom of the -COO- group bonds to 5- or 6-position of the norbornane ring, and when m = 1, the silicon atom bonds to 4- or 5-position of the upper tetracyclododecane ring and the carbon atom of the -COO- group bonds to 9- or 10-position of the tetracyclododecane ring.

As preferable examples of the structural unit (1) of the polysiloxane (1-1), units obtainable by condensation of the compounds shown by the above formulas (I-1-1) to (I-1-4) or the compounds shown by the above formulas (I-2-1) to (I-2-4) described as preferable examples of the silane compound (I), and the like can be given. A unit obtainable by condensation of the silane compound of the above formula (I-1-1) and the like are particularly preferable.

The structural unit (1) may be present in the polysiloxane (1-1) either individually or in combination of two or more.

As examples of the linear or branched alkyl group having 1 to 4 carbon atoms represented by R³ in the formula (2), a methyl group, ethyl group, n-propyl group, i-propyl group, n-butyl group, 2-methylpropyl group, 1-methylpropyl group, and t-butyl group can be given.

Of these alkyl groups, a methyl group, ethyl group, n-propyl group, and the like are preferable.

As examples of the monovalent alicyclic hydrocarbon group having 4 to 20 carbon atoms represented by R³ or a divalent alicyclic hydrocarbon group having 4 to 20 carbon atoms formed by combination of any two of R³ groups together with the carbon atom to which these R³ groups bond, groups derived from a cycloalkane such as cyclobutane, cyclopentane, cyclohexane, cycloheptane, or cyclooctane and groups derived from a bridged hydrocarbon such as adamantane, bicyclo[2.2.1]heptane, or tetracyclo[6.2.1.1^{3,6}.0^{2,7}]dodecane, tricyclo[5.2.1.0^{2,6}]decane, or the like can be given.

Of these monovalent alicyclic hydrocarbon groups and divalent alicyclic hydrocarbon groups, the groups derived from cyclopentane, cyclohexane, adamantane, bicyclo[2.2.1]heptane, and the like are preferable.

As examples of the derivatives of the monovalent or divalent alicyclic hydrocarbon groups, groups having at least one substituent such as a hydroxyl group; a carboxyl group; an oxo group (=O); hydroxyalkyl groups having 1 to 4 carbon atoms such as a hydroxyethyl group, 1-hydroxyethyl group, 2-hydroxyethyl group, 1-hydroxypropyl group, 2-hydroxypropyl group, 3-hydroxypropyl group, 2-hydroxybutyl group, 3-hydroxybutyl group, and 4-hydroxybutyl group; alkoxyl groups having 1 to 4 carbon atoms such as a methoxy group, ethoxy group, n-propoxy group, i-propoxy group, n-butoxy group, 2-methylpropoxy group, 1-methylpropoxy group, and t-butoxy group; a cyano group; and cyanoalkyl groups having 2 to 5 carbon atoms such as a cyanomethyl group, 2-cyanoethyl group, 3-cyanopropyl group, and 4-cyanobutyl group can be given.

Of these substituents, a hydroxyl group, carboxyl group, hydroxymethyl group, cyano group, cyanomethyl group, and the like are preferable.

As examples of the structure represented by -C(R³)₃ in the formula (2): trialkylmethyl groups such as a t-butyl group, 2-methyl-2-butyl group, 2-ethyl-2-butyl group, 3-methyl-3-butyl group, 3-ethyl-3-butyl group, and 3-methyl-3-pentyl group; alkyl-substituted bridged hydrocarbon groups such as a 2-methyladamantan-2-yl group, 2-methyl-3-hydroxyadamantan-2-yl group, 2-ethyladamantan-2-yl group, 2-ethyl-3-hydroxyadamantan-2-yl group, 2-n-propyladamantan-2-yl group, 2-n-butyladamantan-2-yl group, 2- methoxymethyladamantan-2-yl group, 2-methoxymethyl-3-hydroxyadamantan-2-yl group, 2-ethoxymethyladamantan-2-yl group, 2-n-propoxymethyladamantan-2-yl group, 2-methylbicyclo[2.2.1]heptan-2-yl group, 2-methyl-5-hydroxybicyclo[2.2.1]heptan-2-yl group, 2-methyl-6-hydroxybicyclo[2.2.1]heptan-2-yl group, 2-methyl-5-cyanobicyclo[2.2.1]heptan-2-yl group, 2-methyl-6-cyanobicyclo[2.2.1]heptan-2-yl group, 2-ethylbicyclo[2.2.1]heptan-2-yl group, 2-ethyl-5-hydroxybicyclo[2.2.1]heptan-2-yl group, 2-ethyl-6-hydroxybicyclo[2.2.1]heptan-2-yl group, 4-methyltetracyclo[6.2.1.1^{3,6}.0^{2,7}]dodecan-4-yl group, 4-methyl-9-hydroxytetracyclo[6.2.1.1^{3,6}.0^{2,7}]dodecan-4-yl group, 4-methyl-10-hydroxytetracyclo[6.2.1.1^{3,6}.0^{2,7}]dodecan-4-yl group, 4-methyl-9-cyanotetracyclo[6.2.1.1^{3,6}.0^{2,7}]dodecan-4-yl group, 4-methyl-10-cyanotetracyclo[6.2.1.1^{3,6}.0^{2,7}]dodecan-4-yl group, 4-ethyltetracyclo[6.2.1.1^{3,6}.0^{2,7}]dodecan-4-yl group, 4-ethyl-9-hydroxytetracyclo[6.2.1.1^{3,6}.0^{2,7}]dodecan-4-yl group, 4-ethyl-10-hydroxytetracyclo[6.2.1.1^{3,6}.0^{2,7}]dodecan-4-yl group, 8-methyltricyclo[5.2.1.0^{2,6}]decan-8-yl group, 8-methyl-4-hydroxytricyclo[5.2.1.0^{2,6}]decan-8-yl group, 8-methyl-4-cyanotricyclo[5.2.1.0^{2,6}]decan-8-yl group, 8-ethyltricyclo[5.2.1.0^{2,6}]decan-8-yl group, and 8-ethyl-4-hydroxytricyclo[5.2.1.0^{2,6}]decan-8-yl group; dialkylcycloalkylmethyl groups such as a 1-methyl-1-cyclopentylethyl group, 1-methyl-1-(2-hydroxycyclopentyl)ethyl group, 1-methyl-1-(3-hydroxycyclopentyl)ethyl group, 1-methyl-1-cyclohexylethyl group, 1-methyl-1-(3-hydroxycyclohexyl)ethyl group, 1-methyl-1-(4-hydroxycyclohexyl)ethyl group, 1-methyl-1-cycloheptylethyl group, 1-methyl-1-(3-hydroxycycloheptyl)ethyl group, and 1-methyl-1-(4-hydroxycycloheptyl)ethyl group; alkyl-substituted bridged hydrocarbon group-substituted methyl groups such as a 1-methyl-1-(adamantan-1-yl)ethyl group, 1-methyl-1-(3-hydroxyadamantan-1-yl)ethyl group, 1-methyl-1-(bicyclo[2.2.1]heptan-2-yl)ethyl group, 1-methyl-1-(5-hydroxybicyclo[2.2.1]heptan-2-yl)ethyl group, 1-methyl-1-(6-hydroxybicyclo[2.2.1]heptan-2-yl)ethyl group, 1-methyl-1-(tetracyclo[6.2.1.1^{3,6}.0^{2,7}]dodecan-4-yl)ethyl group, 1-methyl-1-(9-hydroxytetracyclo[6.2.1.1^{3,6}.0^{2,7}]dodecan-4-yl)ethyl group, 1-methyl-1-(10-hydroxytetracyclo[6.2.1.1^{3,6}.0^{2,7}]dodecan-4-yl)ethyl group, 1-methyl-1-(tricyclo[5.2.1.0^{2,6}]decan-8-yl)ethyl group, and 1-methyl-1-(4-hydroxytricyclo[5.2.1.0^{2,6}]decan-8-yl)ethyl group; alkyldicycloalkylmethyl groups such as a 1,1-dicyclopentylethyl group, 1,1-di(2-hydroxycyclopentyl)ethyl group, 1, 1-di(3-hydroxycyclopentyl)ethyl group, 1,1-dicyclohexylethyl group, 1,1-di(3-hydroxycyclohexyl)ethyl group, 1,1-di(4-hydroxycyclohexyl)ethyl group, 1,1-dicycloheptylethyl group, 1,1-di(3-hydroxycycloheptyl)ethyl group, and 1,1-di(4-hydroxycycloheptyl)ethyl group; alkyl-substituted di(bridged hydrocarbon group)-substituted methyl groups such as a 1,1-di(adamantan-1-yl)ethyl group, 1,1-di-(3-hydroxyadamantan-1-yl)ethyl group, 1, 1-di(bicyclo[2.2.1]heptan-2-yl)ethyl group, 1,1-di(5-hydroxybicyclo[2.2.1]heptan-2-yl)ethyl group, 1,1-di(6-hydroxybicyclo[2.2.1]heptan-2-yl)ethyl group, 1, 1-di(tetracyclo[6.2.1.1^{3,6}.0^{2,7}]dodecan-4-yl)ethyl group, 1, 1-di(9-hydroxytetracyclo[6.2.1.1^{3,6}.0^{2,7}]dodecan-4-yl)ethyl group, 1,1-di(10-hydroxytetracyclo[6.2.1.1^{3,6}.0^{2,7}]dodecan-4-yl)ethyl group, 1,1-di(tricyclo[5.2.1.0^{2,6}]decan-8-yl)ethyl group, and 1,1-di(4-hydroxytricyclo[5.2.1.0^{2,6}]decan-8-yl)ethyl group; and the like can be given.

As the structure corresponding to -C(R³)₃ in the structural unit (2), a t-butyl group, 2-methyladamantan-2-yl group, 2-ethyladamantan-2-yl group, 2-n-propyladamantan-2-yl group, 2-methoxymethyladamantan-2-yl group, 2-ethoxymethyladamantan-2-yl group, 2-methylbicyclo[2.2.1]heptan-2-yl group, 2-ethylbicyclo[2.2.1]heptan-2-yl group, 1-methyl-1-(adamantan-1-yl)ethyl group, and 1-methyl-1-(bicyclo[2.2.1]heptan-2-yl)ethyl group, and the like are particularly preferable.

The structure of the carboxylic acid ester in the structural unit (2) forms an acid-dissociable group which dissociates by the action of an acid and produces a carboxyl group.

Both 0 and 1 are preferable as m in the structural unit (2).

The structural unit (2) may be present in the polysiloxane (1-1) either individually or in combination of two or more.

The polysiloxane (1-1) may contain one or more structural units other than the structural unit (1) and the structural unit (2) (such other structural units are hereinafter referred to as "other structural units (β)".

As examples of the other structural unit (β), in addition to the structural units derived from a trifunctional or tetrafunctional silane compound in respect of a condensation reaction, such as the structural units of the formulas (3), (4), or (5) given as examples of the other structural unit (α), the structural units derived from a difunctional silane compound in respect of a condensation reaction can be given.

The content of the structural unit (1) in the polysiloxane (1-1) is usually 3 to 50 mol%, preferably 3 to 45 mol%, and still more preferably 5 to 40 mol%. If the content of the structural unit (1) is less than 3 mol%, resolution as a resist tends to decrease. If the content is more than 50 mol%, on the other hand, sensitivity as a resist tends to decrease.

The content of the structural unit (2) is usually 3 to 50 mol%, preferably 3 to 45 mol%, and still more preferably 5 to 40 mol%. If the content of the structural unit (2) is less than 3 mol%, resolution as a resist tends to decrease. If the content is more than 50 mol%, on the other hand, sensitivity as a resist tends to decrease.

The content of the other structural units β is usually 85 mol% or less, and preferably 80 mol% or less. If the content of the other structural unit is more than 85 mol%, resolution as a resist tends to decrease.

The polystyrene-reduced weight average molecular weight of the polysiloxane (1-1) determined by gel permeation chromatography (GPC) (hereinafter referred to as "Mw") is 500 to 1,000,000, preferably 500 to 100,000, and particularly preferably 500 to 40,000. If the Mw is less than 500, the glass transition temperature (Tg) of the resulting resin tends to decrease. If the Mw exceeds 1,000,000, on the other hand, solubility of the resulting resin in solvents tends to decrease.

The polysiloxane (1-1) has high transparency to radiation with a wavelength of 193 nm or less and exhibits superior dry etching resistance. The resin composition is very useful not only as a resin component in a chemically-amplified resist for microprocessing using radiation such as deep ultraviolet radiation, electron beams, and X-rays, but also for formed articles, films, laminate materials, paints, and the like by itself or as a mixture with various other siloxane resins.

### Method for producing polysiloxane (1) and polysiloxane (1-1)

The polysiloxane (1) can be produced by, for example, polycondensation of a silane compound (I), optionally together with a silane compound providing the other structural unit α under acidic conditions or basic conditions in the presence or absence of a solvent, preferably initially under acidic conditions, followed by a continued reaction under basic conditions.

The polysiloxane (1-1) can be produced by, for example, polycondensation of a silane compound (I) and a silane compound providing the structural unit (2), optionally together with a silane compound providing the other structural unit β under acidic conditions or basic conditions in the presence or absence of a solvent, preferably initially under acidic conditions, followed by a continued reaction under basic conditions.

As the silane compounds providing the other structural unit α or other structural unit β in the above polycondensation, the compounds of the following formula (8) or (9) and the like can be used. Part or whole of each silane compound may be used as a partial condensate, 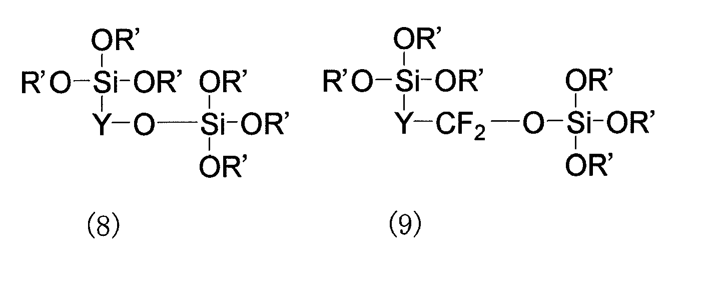 wherein R' individually represents a linear, branched, or cyclic alkyl group having 1 to 20 carbon atoms and Y has the same meaning as defined for the formulas (6) and (7).

The polycondensation method for producing the polysiloxane (1) and polysiloxane (1-1) will now be described.

An acidic catalyst is used in the polycondensation under acidic conditions.

As examples of the acidic catalyst, hydrochloric acid, sulfuric acid, nitric acid, formic acid, acetic acid, n-propionic acid, butyric acid, valeric acid, oxalic acid, malonic acid, succinic acid, maleic acid, fumaric acid, adipic acid, phthalic acid, terephthalic acid, acetic anhydride, maleic anhydride, citric acid, boric acid, phosphoric acid, titanium tetrachloride, zinc chloride, aluminum chloride, benzenesulfonic acid, p-toluenesulfonic acid, and methanesulfonic acid can be given.

Of these acidic catalysts, hydrochloric acid, sulfuric acid, acetic acid, oxalic acid, malonic acid, maleic acid, fumaric acid, acetic anhydride, maleic anhydride, and the like are preferable.

These acidic catalysts may be used either individually or in combination of two or more.

The acidic catalysts are usually used in the amount of 0.01 to 10,000 parts by weight, for 100 parts by weight of the total amount of the silane compounds.

A basic catalyst is used in the polycondensation and reaction under basic conditions. As examples of inorganic bases among the above basic catalysts, lithium hydroxide, sodium hydroxide, potassium hydroxide, calcium hydroxide, barium hydroxide, sodium hydrogencarbonate, potassium hydrogencarbonate, sodium carbonate, and potassium carbonate can be given.

In addition, as examples of the organic bases among the above basic catalyst, linear, branched, or cyclic monoalkylamines such as n-hexylamine, n-heptylamine, n-octylamine, n-nonylamine, n-decylamine, and cyclohexylamine; linear, branched, or cyclic dialkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; linear, branched, or cyclic trialkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine, and tricyclohexylamine; aromatic amines such as aniline, N-methylaniline, N,N-dimethylaniline, 2-methylaniline, 3-methylaniline, 4-methylaniline, 4-nitroaniline, diphenylamine, triphenylamine, and naphthylamine; diamines such as ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, and 1,3-bis[1-(4-aminophenyl)-1-methylethyl]benzene; imidazoles such as imidazole, benzimidazole, 4-methylimidazole, and 4-methyl-2-phenylimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine and 1-(2'-hydroxyethyl)piperazine; other nitrogen-containing heterocyclic compounds such as pyrazine, pyrazole, pyridazine, quinoxaline, purine, pyrrolidine, piperidine, morpholine, 4-methylmorpholine, 1,4-dimethylpiperazine, and 1,4-diazabicyclo[2.2.2]octane; and the like can be given.

Of these basic catalysts, triethylamine, tri-n-propylamine, tri-n-butylamine, pyridine, and the like are preferable.

These basic catalysts may be used either individually or in combination of two or more. The basic catalyst is usually used in an amount of 0.01 to 10,000 parts by weight for 100 parts by weight of all of the silane compounds.

As examples of the solvent used in the polycondensation, linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; alcohols such as ethanol, n-propanol, i-propanol, n-butanol, t-butanol, cyclohexanol, ethylene glycol monomethyl ether, ethylene glycol monoethyl ether, ethylene glycol mono-n-propyl ether, ethylene glycol mono-n-butyl ether, propylene glycol monomethyl ether, propylene glycol monoethyl ether, and propylene glycol mono-n-propyl ether; dialkylene glycol dialkyl ethers such as diethylene glycol dimethyl ether, diethylene glycol diethyl ether, diethylene glycol di-n-propyl ether, and diethylene glycol di-n-butyl ether; ethylene glycol monoalkyl ether acetates such as ethylene glycol monomethyl ether acetate, ethylene glycol monoethyl ether acetate, and ethylene glycol mono-n-propyl ether acetate; aromatic hydrocarbons such as toluene and xylene; other esters such as ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, and ethyl pyruvate; N-methylpyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzylalcohol, benzyl acetate, ethyl benzoate, diethyl oxalate, diethyl maleate, γ-butyrolactone, ethylene carbonate, propylene carbonate; and the like can be given.

These solvents may be used either individually or in combination of two or more.

These solvents are usually used in the amount of 2,000 parts by weight or less for 100 parts by weight of all of the silane compounds.

The polycondensation reaction for producing the polysiloxane (1) and polysiloxane (1-1) can be preferably carried out either in the presence or absence of a solvent, such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, 2-octanone, cyclopentanone, 3-methylcyclopentanone, cyclohexanone, 2-methylcyclohexanone, 2,6-dimethylcyclohexanone, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, and ethylene glycol mono-n-propyl ether acetate.

In addition, water may be added to the reaction mixture of the polycondensation reaction. The amount of water to be added is usually 10,000 parts by weight or less for 100 parts by weight of all of the silane compounds. Under the acidic or basic conditions, the polycondensation reaction is carried out at a temperature of usually -50 to 300°C, and preferably 20 to 100°C, usually for a period of one minute to 100 hours.

### Radiation-sensitive resin composition

The radiation-sensitive resin composition comprises (A) the polysiloxane (1) and (B) a photoacid generator (hereinafter referred to as "acid generator (B)").

As specific embodiments of the radiation-sensitive resin composition of the present invention, a composition in which (A) the polysiloxane (1) has the structural unit (1) and the structural unit (3), a composition in which the polysiloxane (1) has the structural unit (1) and the structural unit (2), and a composition in which the polysiloxane (1) has the structural unit (1), the structural unit (2), and the structural unit (3) can be given.

The polysiloxane (1) can be used either individually or in combination of two or more in the radiation-sensitive resin composition of the present invention.

One or more other polysiloxanes can be used in combination with the polysiloxane (1) in the radiation-sensitive resin composition of the present invention.

As examples of the aforementioned other polysiloxanes, polysiloxanes having one or more structural units represented by the above formulas (3), (4), or (5) can be given.

### Acid generator (B)

The acid generator (B) is a component generating an acid by exposure to radiation. The acid causes an acid-dissociable group in the polysiloxane (1) to dissociate. As a result, the exposed part of the resist film becomes readily soluble in an alkaline developer, thereby forming a positive-tone resist pattern.

The type of the acid generator (B) is not specifically limited insofar as it can exhibit the above action. An acid generator containing at least one compound that generates sulfonic acid or carboxylic acid (hereinafter referred to as "acid generator (B1)") upon exposure is preferable.

As the sulfonic acid or carboxylic acid generated from the acid generator (B1), those described in Japanese Patent Application Laid-open No. 2002-220471 can be given. Specific examples include sulfonic acids or carboxylic acids having a methyl group, ethyl group, n-propyl group, i-propyl group, n-butyl group, i-butyl group, sec-butyl group, t-butyl group, n-pentyl group, n-hexyl group, n-heptyl group, n-octyl group, trifluoromethyl group, pentafluoroethyl group, heptafluoro-n-propyl group, heptafluoro-i-propyl group, nonafluoro-n-butyl group, nonafluoro-i-butyl group, nonafluoro-sec-butyl group, nonafluoro-t-butyl group, perfluoro-n-pentyl group, perfluoro-n-hexyl group, perfluoro-n-heptyl group, perfluoro-n-octyl group, groups originating from norbornane, dinorbornane, adamantane, or camphor, and substituted derivative of these groups.

As examples of the acid generator (B1), onium salt compounds generating the above sulfonic acids or carboxylic acids, sulfone compounds generating the above sulfonic acids, oxime compounds generating the above sulfonic acids, carboxylic acid compounds generating the above carboxylic acids, diazoketone compounds generating the above sulfonic acids or carboxylic acids, and halogen-containing compounds generating the above sulfonic acids or carboxylic acids can be given. As examples of the onium salt compounds, iodonium salts and sulfonium salts (including tetrahydrothiophenium salts) can be given. Specific examples include diphenyliodonium salt, dinaphthyliodonium salt, triphenylsulfonium salt, trinaphthylsulfonium salt, diphenylmethylsulfonium salt, dicyclohexyl-2-oxocyclohexylsulfonium salt, 2-oxocyclohexyldimethylsulfonium salt, phenylbenzylmethylsulfonium salt, 1-naphthyldimethylsulfonium salt, 1-naphthyldiethylsulfonium salt, 1-(naphthalen-1-yl)tetrahydrothiophenium salt, and derivatives of these salts with one or more substituents such as a hydroxyl group, alkyl group, alkoxyl group, cyano group, and nitro group.

As examples of the sulfone compounds, β-ketosulfones, β-sulfonylsulfones, and α-diazo compounds of these compounds can be given.

As examples of the sulfonic acid compound, sulfonic acid esters, sulfonic acid imides, arylsulfonic acid esters, and imino sulfonates can be given.

As examples of the oxime compound, aryl group-containing oximesulfonic acids can be given.

As examples of the carboxylic acid compound, carboxylic acid esters, carboxylic acid imides, and carboxylic acid cyanates can be given.

As examples of the diazoketone compound, 1,3-diketo-2-diazo compounds, diazobenzoquinone compounds, and diazonaphthoquinone compounds can be given.

As examples of the halogen-containing compound, haloalkyl group-containing hydrocarbon compounds and haloalkyl group-containing heterocyclic compounds can be given.

In the present invention, either one type of acid generator (B) can be used alone or a mixture of two or more types may be used.

The amount of the acid generator (B) is usually 0.1 to 30 parts by weight, and preferably 0.5 to 20 parts by weight for 100 parts by weight of the total amount of polysiloxane components from the viewpoint of ensuring sensitivity and developability as a resist. If the amount of the acid generator (B) is less than 0.1 part by weight, sensitivity and developability of the resulting resist may be decreased. If the amount exceeds 30 parts by weight, it may be difficult to obtain a rectangular resist pattern due to a decrease in transparency to radiation.

### Additives

Additives such as an acid diffusion controller, dissolution controller, and surfactant may be added to the radiation-sensitive resin composition of the present invention.

The acid diffusion controllers control diffusion of an acid generated from the acid generator upon exposure in the resist film to suppress undesired chemical reactions in the unexposed area.

The addition of such an acid diffusion controller improves storage stability of the resulting radiation-sensitive resin composition and resolution as a resist. Moreover, the addition of the acid diffusion controller prevents the line width of the resist pattern from changing due to changes in the post-exposure delay (PED) between exposure and development, whereby a composition with remarkably superior process stability can be obtained.

As the acid diffusion controller, an organic compound containing nitrogen of which the basicity does not change during exposure or heating for forming a resist pattern is preferable.

As examples of the nitrogen-containing organic compounds, compounds shown by the following formula (10) (hereinafter referred to as "acid diffusion controller (C)") can be given, 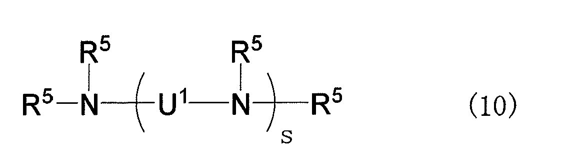 wherein R⁵ individually represents a hydrogen atom, a linear, branched, or cyclic alkyl group, aryl group, or aralkyl group which is either substituted or unsubstituted with a functional group such as a hydroxyl group, U¹ is a divalent organic group, and s is an integer of 0 to 2.

In the acid diffusion controller (C), the compound having s = 0 is defined as an acid diffusion controller (C1) and the compound having s = 1 to 2 is defined as a acid diffusion controller (C2). Polyamino compounds and polymers having three or more nitrogen atoms are collectively referred to as "acid diffusion controller (C3)".

As examples of nitrogen-containing organic compounds other than the acid diffusion controller (C), quaternary ammonium hydroxide compounds, amide group-containing compounds, urea compounds, and nitrogen-containing heterocyclic compounds can be given.

Examples of the acid diffusion controller (C1) include mono(cyclo)alkylamines such as n-hexylamine, n-heptylamine, n-octylamine, n-nonylamine, n-decylamine, and cyclohexylamine; di(cyclo)alkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; tri(cyclo)alkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine, and tricyclohexylamine; and aromatic amines such as aniline, N-methylaniline, N,N-dimethylaniline, 2-methylaniline, 3-methylaniline, 4-methylaniline, 4-nitroaniline, 2,6-dimethylaniline, 2,6-diisopropylaniline, diphenylamine, triphenylamine, and naphthylamine.

Examples of the acid diffusion controller (C2) include ethylenediamine, N,N,N',N'-tetramethylethylenediamine, N,N,N',N'-tetrakis(2-hydroxypropyl)ethylenediamine, tetramethylenediamine, 1,3-bis[1-(4-aminophenyl)-1-methylethyl]benzenetetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, 1,3-bis[1-(4-aminophenyl)-1-methylethyl]benzene, bis(2-dimethylaminoethyl) ether, and bis(2-diethylaminoethyl) ether.

Examples of the acid diffusion controller (C3) include polyethyleneimine, polyallylamine, and a polymer of 2-dimethylaminoethylacrylamide.

As examples of the quaternary ammonium hydroxide compound, tetramethylammonium hydroxide, tetraethylammonium hydroxide, tetra-n-propylammonium hydroxide, and tetra-n-butylammonium hydroxide can be given.

As examples of the amide group-containing compounds, N-t-butoxycarbonyl group-containing amino compounds such as N-t-butoxycarbonyl-di-n-octylamine, N-t-butoxycarbonyl-di-n-nonylamine, N-t-butoxycarbonyl-di-n-decylamine, N-t-butoxycarbonyl-dicyclohexylamine, N-t-butoxycarbonyl-1-adamantylamine, N-t-butoxycarbonyl-N-methyl-1-adamantylamine, N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N'-di-t-butoxycarbonylhexamethylenediamine, N,N,N'N'-tetra-t-butoxycarbonylhexamethylenediamine, N,N'-di-t-butoxycarbonyl-1,7-diaminoheptane, N,N'-di-t-butoxycarbonyl-1,8-diaminooctane, N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-diaminodiphenylmethane, N-t-butoxycarbonylbenzimidazole, N-t-butoxycarbonyl-2-methylbenzimidazole, N-t-butoxycarbonyl-2-phenylbenzimidazole, formamide, N-methylformamide, N,N-dimethylformamide, acetamide, N-methylacetamide, N,N-dimethylacetamide, propioneamide, benzamide, pyrrolidone, N-methylpyrrolidone, and the like can be given.

As examples of the urea compound, urea, methylurea, 1,1-dimethylurea, 1,3-dimethylurea, 1,1,3,3-tetramethylurea, 1,3-diphenylurea, and tri-n-butylthiourea can be given.

Examples of the nitrogen-containing heterocyclic compounds include: imidazoles such as imidazole, 4-methylimidazole, 1-benzyl-2-methylimidazole, 4-methyl-2-phenylimidazole, benzimidazole, and 2-phenylbenzimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine and 1-(2-hydroxyethyl)piperazine; pyrazine, pyrazole, pyridazine, quinoxaline, purine, pyrrolidine, piperidine, 3-piperidino-1,2-propanediol, morpholine, 4-methylmorpholine, 1,4-dimethylpiperazine, and 1,4-diazabicyclo[2.2.2]octane.

These acid diffusion controllers may be used either individually or in combinations of two or more.

The amount of the acid diffusion controller to be added is usually 100 mol% or less, preferably 50 mol% or less, and still more preferably 30 mol% or less, of the polysiloxane (B). If the amount of the acid diffusion controller exceeds 100 mol%, sensitivity of the resulting resist and developability of the exposed region may be decreased. If the amount of the acid diffusion controller is less than 0.1 mol%, the pattern shape or dimensional accuracy of the resulting resist may be decreased depending on the process conditions.

As the dissolution controller, a compound possessing an effect of controlling the solubility contrast and/or rate of dissolution of the resist can be given, for example.

The amount of the dissolution controllers to be added is 50 parts by weight or less, and preferably 30 parts by weight or less for 100 parts by weight of the total polysiloxane components. If the amount of the dissolution controller exceeds 50 parts by weight, heat resistance as a resist tends to decrease.

Surfactants improve applicability, striation, developability, and the like.

As examples of the surfactant, nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, and polyethylene glycol distearate; and commercially available products such as KP341 (manufactured by Shin-Etsu Chemical Co., Ltd.), POLYFLOW No. 75, No. 95 (manufactured by Kyoeisha Chemical Co., Ltd.), FTOP EF301, EF303, EF352 (manufactured by Tohkem Products Corporation), MEGAFAC F171, F173 (manufactured by Dainippon Ink and Chemicals, Inc.), Fluorad FC430, FC431 (manufactured by Sumitomo 3M Ltd.), Asahi Guard AG710, and Surflon S-382, SC-101, SC-102, SC-103, SC-104, SC-105, SC-106 (manufactured by Asahi Glass Co., Ltd.) can be given.

These surfactants may be used either individually or in combination of two or more.

The amount of the surfactants to be added is usually 2 parts by weight or less for 100 parts by weight of the total polysiloxane components.

As other additives, halation inhibitors, adhesion promoters, storage stabilizers, anti-foaming agents, and the like can be given.

### Preparation of composition solution

The radiation-sensitive resin composition of the present invention is usually used in the form of a composition solution prepared by dissolving the composition in a solvent so that the total solid content is usually 1 to 25 wt%, and preferably 2 to 15 wt%, and filtering the solution using a filter with a pore diameter of about 0.2 µm, for example.

As examples of solvents used for preparation of the composition solution, linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; fluorine-containing solvents, for example, fluorine-containing alcohols such as 2,3-difluorobenzyl alcohol, 2,2,2-trifluoroethanol, 1,3-difluoro-2-propanol, 1,1,1-trifluoro-2-propanol, 3,3,3-trifluoro-1-propanol, 2,2,3,3,4,4,4-heptafluoro-1-butanol, 2,2,3,3,4,4,5,5-octafluoro-1-pentanol, 3,3,4,4,5,5,5-heptafluoro-2-pentanol, 1H,1H-perfluoro-1-octanol, 1H,1H,2H,2H-perfluoro-1-octanol, 1H,1H,9H-perfluoro-1-nonanol, 1H,1H,2H,3H,3H-perfluorononane-1,2-diol, 1H,1H,2H,2H-perfluoro-1-decanol, 1H,1H,2H,3H,3H-perfluoroundecane-1,2-diol; fluorine-containing esters such as 2,2,2-trifluoroethyl butyrate, ethyl heptafluorobutyrate, ethyl heptafluorobutylacetate, ethyl hexafluoroglutarate, ethyl 3-hydroxy-4,4,4-trifluorobutyrate, ethyl 2-methyl-4,4,4-trifluoroacetoacetate, ethyl pentafluorobenzoate, ethyl pentafluoropropionate, ethyl perfluorooctanoate, ethyl 4,4,4-trifluoroacetoacetate, ethyl 4,4,4-trifluorobutyrate, ethyl 4,4,4-trifluorocrotonate, ethyl trifluorosulfonate, ethyl 3-(trifluoromethyl)butyrate, ethyl trifluoropyruvate, ethyl trifluoroacetate, isopropyl 4,4,4-trifluoroacetoacetate, methyl perfluorodecanoate, methyl perfluoro(2-methyl-3-oxahexanoate), methyl perfluorononanoate, methyl perfluorooctanoate, methyl 2,3,3,3-tetrafluoropropionate, methyl trifluoroacetoacetate, methyl perfluoro(2,5,8-trimethyl-3,6,9-trioxadodecanoate), propylene glycol trifluoromethyl ether acetate, propylene glycol methyl ether trifluoromethylacetate, n-butyl trifluoromethylacetate, methyl 3-trifluoromethoxypropionate, 1,1,1-trifluoro-2-propylacetate, and n-butyl trifluoroacetate; fluorine-containing ethers such as 2-fluoroanisole, 3-fluoroanisole, 4-fluoroanisole, 2,3-difluoroanisole, 2,4-difluoroanisole, 2,5-difluoroanisole, 5,8-difluoro-1,4-benzodioxane, trifluoroacetaldehyde ethyl hemiacetal, 2H-perfluoro(5-methyl-3,6-dioxanonane), 2H-perfluoro(5,8,11,14-tetramethyl-3,6,9,12,15-pentaoxaoctadecane), (perfluoro-n-butyl)tetrahydrofuran, perfluoro(n-butyltetrahydrofuran), and propylene glycol trifluoromethyl ether; fluorine-containing ketones such as 2,4-difluoropropiophenone, fluorocyclohexane, 1,1, 1,2,2,3,3-heptafluoro-7,7-dimethyl-4,6-octanedione, 1,1,1,3,5,5,5-heptafluoropentane-2,4-dione, 3,3,4,4,5,5,5-heptafluoro-2-pentanone, 1,1,1,2,2,6,6,6-octafluoro-2,4-hexanedione, trifluorobutanol-1,1,1-trifluoro-5-methyl-2,4-hexanedione, and perfluorocyclohexanone; fluorine-containing amines such as trifluoroacetamide, perfluorotributylamine, perfluorotrihexylamine, perfluorotripentylamine, and perfluorotripropylamine; fluorine-substituted cyclic hydrocarbons such as 2,4-difluorotoluene, perfluorodecalin, perfluoro(1,2-dimethylcyclohexane), and perfluoro(1,3-dimethylcyclohexane); n-propylalcohol, i-propylalcohol, n-butylalcohol, t-butylalcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, ethyl pyruvate, N-methyl pyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, and propylene carbonate can be given.

These solvents may be used either individually or in combination of two or more. Among these solvents, linear or branched ketones, cyclic ketones, propylene glycol monoalkyl ether acetates, alkyl 2-hydroxypropionates, alkyl 3-alkoxypropionates, and fluorine-containing solvents are preferable.

### Formation of resist pattern

In the radiation-sensitive resin composition of the present invention, an acid is generated from the acid generator upon exposure to radiation. The acid-dissociable group in the polysiloxane (1) dissociates by the action of the acid and generates a carboxyl group. As a result, solubility of the exposed part of the resist in an alkaline developer increases, whereby the exposed part is dissolved in an alkaline developer and removed to produce a positive-tone resist pattern.

A resist pattern is formed from the radiation-sensitive resin composition of the present invention by applying the composition solution to, for example, a substrate such as a silicon wafer or a wafer coated with aluminum, or a substrate with an under layer previously formed thereon, using an appropriate application method such as rotational coating, cast coating, and roll coating to form a resist film. The resist film is then optionally pre-baked (hereinafter called "PB") and exposed to radiation to form a desired resist pattern. Deep ultraviolet rays such as an F₂ excimer laser (wavelength: 157 nm), ArF excimer laser (wavelength: 193 nm), electron beams, X-rays, and the like are preferable as the radiation used here.

In the present invention, it is preferable to perform post-exposure bake (hereinafter called "PEB"). PEB ensures smooth dissociation of the acid-dissociable group from the polysiloxane (1). The heating temperature for PEB is usually 30 to 200°C, and preferably 50 to 170°C, although the heating conditions vary depending on the composition of the resist.

In the present invention, in order to bring out the potential capability of the radiation-sensitive resin composition to the maximum extent, an organic or inorganic under layer film may be formed on the substrate (see, for example, Japanese Patent Publication No. 6-12452). In order to inhibit the effects of basic impurities contained in the environmental atmosphere, an overcoat can be formed on the resist film (see, for example, Japanese Patent Application Laid-open No. 5-188598). These techniques may be used in combination.

The exposed resist film is then developed to form a prescribed resist pattern.

As examples of the developer used for development, alkaline aqueous solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, and 1,5-diazabicyclo-[4.3.0]-5-nonene are preferable.

The concentration of the alkaline aqueous solution is usually 10 wt% or less. If the concentration of the alkaline aqueous solution exceeds 10 wt%, an unexposed part may be dissolved in the developer.

Organic solvents or the like may be added to the developer containing an alkaline aqueous solution.

As examples of the organic solvents, ketones such as acetone, 2-butanone, 4-methyl-2-pentanone, cyclopentanone, cyclohexanone, 3-methylcyclopentanone, and 2,6-dimethylcyclohexanone; alcohols such as methyl alcohol, ethyl alcohol, n-propyl alcohol, i-propyl alcohol, n-butyl alcohol, t-butyl alcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, and dimethylformamide can be given.

These organic solvents may be used either individually or in combination of two or more.

The amount of the organic solvent to be used is preferably 100 vol% or less of the alkaline aqueous solution. The amount of the organic solvent exceeding 100 vol% may decrease developability, giving rise to a larger undeveloped portion in the exposed area.

In addition, surfactants or the like may be added to the developer containing the alkaline aqueous solution in an appropriate amount.

After development using the alkaline aqueous solution developer, the resist film is generally washed with water and dried.

### BEST MODE FOR CARRYING OUT THE INVENTION

The present invention is described below in more detail by examples. However, these examples should not be construed as limiting the present invention.

### Mw:

Mw of the polysiloxanes obtained in the Examples and Comparative Examples described below and the polymers obtained in the Preparation Example described below was measured by gel permeation chromatography (GPC) using GPC columns (manufactured by Tosoh Corp., G2000HXL × 2, G3000HXL × 1, G4000HXL × 1) under the following conditions. Flow rate: 1.0 ml/minute, eluate: tetrahydrofuran, column temperature: 40°C, standard reference material: monodispersed polystyrene

### Synthesis Example 1 (Synthesis of silane compound (I))

A three-necked flask equipped with a stirrer, a reflux condenser, and a thermometer was charged with 220 g of triethoxysilane and 198 g of 5-(1-methylcyclopentyl)oxycarbonylbicyclo[2.2.1]hept-2-ene. The mixture was stirred at room temperature and 1 ml of a 0.2 mol chloroplatinic acid (H₂PtCl₆) solution in i-propyl alcohol was added to initiate the reaction. After heating the reaction mixture at 100°C for 30 hours, additional 1 ml of a 0.2 mol i-propyl alcohol solution of chloroplatinic acid was added with heating at 100°C for five hours. The reaction mixture was allowed to cool to room temperature, diluted with n-hexane, and filtered through a suction funnel spread with celite. The solvent was removed from the filtrate by evaporation under reduced pressure to obtain a crude product. The crude product was purified by distillation under reduced pressure to obtain 262 g of a compound as a fraction with a boiling point of 137°C at 0.06 mmHg.

As a result of ¹H-NMR spectrum (chemical shift δ) measurement, this compound was identified to be a compound shown by the above formula (I-1-1) (hereinafter referred to as "compound (a-1)").

### δ (unit ppm):

3.8 (CH₂ group in ethoxy group), 2.7-1.3 (CH group in norbornane ring, CH₂ group in norbornane ring, CH₃ group, CH₂ group in cyclohexane ring), 1.2 (ethoxy group)

### Synthesis Example 2

A compound of the above formula (I-1-2) was obtained in the same manner as in Synthesis Example 1, except for using 5-(1-ethylcyclopentyl)oxycarbonylbicyclo[2.2.1]hept-2-ene instead of 5-(1-methylcyclopentyl)oxycarbonylbicyclo[2.2.1]hept-2-ene.

### Synthesis Example 3

A compound of the above formula (I-1-4) was obtained in the same manner as in Synthesis Example 1, except for using 5-(1-ethylcyclohexyl)oxycarbonylbicyclo[2.2.1]hept-2-ene instead of 5-(1-methylcyclopentyl)oxycarbonylbicydo[2.2.1]hept-2-ene.

### Example 1 (Preparation of polysiloxane (1))

A three-necked flask equipped with a stirrer, a reflux condenser, and a thermometer was charged with 36.3 g of the compound (a-1), 41.32 g of a silane compound of the following formula (b-1) (hereinafter referred to as "compound (b-1)"), 22.39 g of a silane compound of the following formula (b-2) (hereinafter referred to as "compound (b-2)"), 100 g of 4-methyl-2-pentanone, and 23.0 g of a 1.75 wt% aqueous solution of oxalic acid. The mixture was reacted at 60°C for six hours while stirring. The reaction vessel was cooled with ice to terminate the reaction.

34.0 g of distilled water and 47.7 g of triethylamine were added to the reaction solution and stirred at 80°C in a nitrogen stream for six hours, followed by cooling with ice. An aqueous solution of 35.9 g of oxalic acid dissolved in 476.5 g of distilled water was added to the mixture, followed by further stirring. The reaction solution was poured into a separating funnel to remove the water layer. The organic layer was repeatedly washed with ion-exchanged water until the reaction solution became neutral. The solvent was evaporated from the organic layer under reduced pressure to obtain 62.1 g of polysiloxane (1). Mw of the obtained polysiloxane (1) was 1,740.

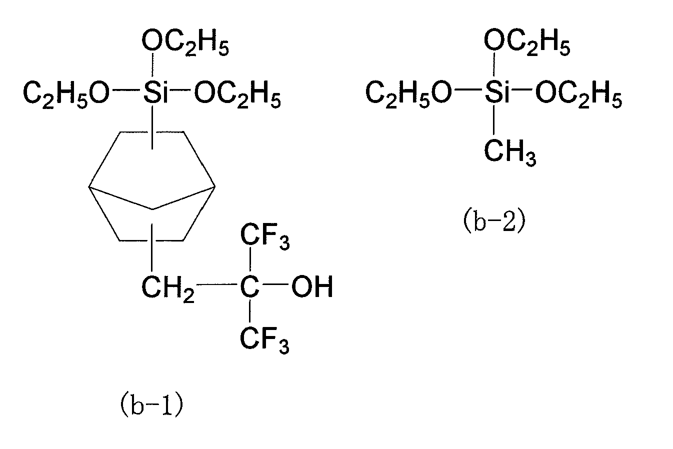

### Example 2 (Preparation of polysiloxane (1))

A three-necked flask equipped with a stirrer, a reflux condenser, and a thermometer was charged with 22.27 g of the compound (a-1), 42.36 g of a silane compound of the following formula (b-3), 19.77 g of a silane compound of the following formula (b-4), 100 g of 4-methyl-2-pentanone, and 14.1 g of a 1.75 wt% aqueous solution of oxalic acid. The mixture was reacted at 60°C for six hours while stirring. The reaction vessel was cooled with ice to terminate the reaction.

21.4 g of distilled water and 29.3 g of triethylamine were added to the reaction solution and stirred at 80°C in a nitrogen stream for six hours, followed by cooling with ice. An aqueous solution of 22.0 g of oxalic acid dissolved in 292.4 g of distilled water was added to the mixture, followed by further stirring. The reaction solution was poured into a separating funnel to remove the water layer. The organic layer was repeatedly washed with ion-exchanged water until the reaction solution became neutral. The solvent was evaporated from the organic layer under reduced pressure to obtain 74.2 g of polysiloxane (1). Mw of the obtained polysiloxane (1) was 2,060.

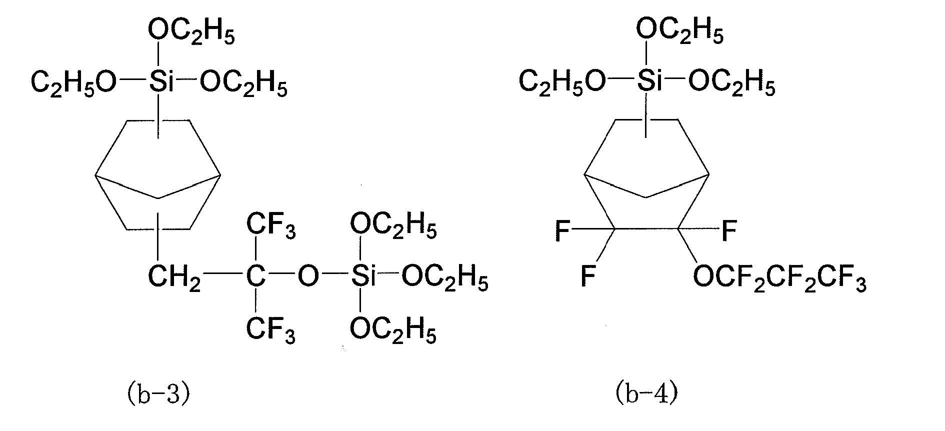

### Example 3 (Preparation of polysiloxane (1))

A three-necked flask equipped with a stirrer, a reflux condenser, and a thermometer was charged with 48.08 g of the compound (a-1), 51.92 g of the compound (b-1), 100 g of 4-methyl-2-pentanone, and 30.53 g of a 1.75 wt% aqueous solution of oxalic acid. The mixture was reacted at 60°C for six hours while stirring. The reaction vessel was cooled with ice to terminate the reaction.

The reaction solution was poured into a separating funnel to remove the water layer. The organic layer was repeatedly washed with ion-exchanged water until the reaction solution became neutral. The solvent was evaporated from the organic layer under reduced pressure to obtain 51.1 g of polysiloxane (1). Mw of the obtained polysiloxane (1) was 1,530.

### Example 4 (Preparation of polysiloxane (1))

A three-necked flask equipped with a stirrer, a reflux condenser, and a thermometer was charged with 31.35 g of the compound (a-1), 17.58 g of the compound (b-1), 50.79 g of the compound (b-2), 100 g of 4-methyl-2-pentanone, and 29.86 g of a 1.75 wt% aqueous solution of oxalic acid. The mixture was reacted at 60°C for six hours while stirring. The reaction vessel was cooled with ice to terminate the reaction.

44.1 g of distilled water and 61.9 g of triethylamine were added to the reaction solution and stirred at 40°C in a nitrogen stream for six hours, followed by cooling with ice. An aqueous solution of 46.5 g of oxalic acid dissolved in 617.6 g of distilled water was added to the mixture, followed by further stirring. The reaction solution was poured into a separating funnel to remove the water layer. The organic layer was repeatedly washed with ion-exchanged water until the reaction solution became neutral. The solvent was evaporated from the organic layer under reduced pressure to obtain 63.1 g of polysiloxane (1). Mw of the obtained polysiloxane (1) was 2,540.

### Comparative Example 1 (Preparation of comparative polysiloxane)

A three-necked flask equipped with a stirrer, a reflux condenser, and a thermometer was charged with 34.68 g of a silane compound shown by the following formula (r-1), 42.36 g of the compound (b-1), 22.96 g of the compound (b-2), 100 g of 4-methyl-2-pentanone, and 23.6 g of a 1.75 wt% aqueous solution of oxalic acid. The mixture was reacted at 60°C for six hours while stirring. The reaction vessel was cooled with ice to terminate the reaction.

34.9 g of distilled water and 48.9 g of triethylamine were added to the reaction solution and stirred at 80°C in a nitrogen stream for six hours, followed by cooling with ice. An aqueous solution of 36.8 g of oxalic acid dissolved in 488.5 g of distilled water was added to the mixture, followed by further stirring. The reaction solution was poured into a separating funnel to remove the water layer. The organic layer was repeatedly washed with ion-exchanged water until the reaction solution became neutral. The solvent was evaporated under reduced pressure from the organic layer to obtain 60.9 g of polysiloxane. Mw of the polysiloxane was 1,910.

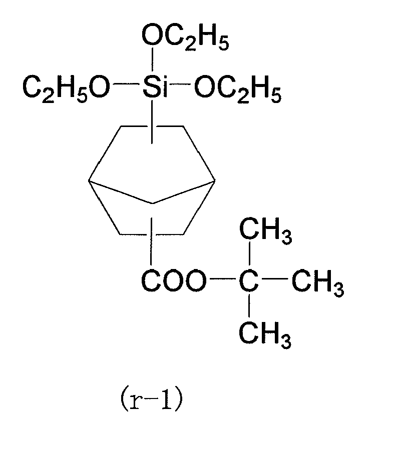

### Preparation Example (Preparation of under layer film-forming composition)

A separable flask equipped with a thermometer was charged with 100 parts by weight of acenaphthylene, 78 parts by weight of toluene, 52 parts by weight of dioxane, and 3 parts by weight of azobisisobutyronitrile in a nitrogen atmosphere. The mixture was stirred for five hours at 70°C. Next, 5.2 parts by weight of p-toluenesulfonic acid monohydrate and 40 parts by weight of paraformaldehyde were added. After heating to 120°C, the mixture was stirred for six hours. The reaction solution was poured into a large amount of isopropyl alcohol. The resulting precipitate was collected by filtration and dried at 40°C under reduced pressure to obtain a polymer having a Mw of 22,000.

10 parts by weight of the obtained polymer, 0.5 part by weight of bis(4-t-butylphenyl)iodonium 10-camphorsulfonate, 0.5 part by weight of 4,4'-[1-{4-(1-[4-hydroxyphenyl]-1-methylethyl)phenyl} ethylidene]bisphenol, and 89 parts by weight of cyclohexanone were mixed to prepare a homogeneous solution. The solution was filtered using a membrane filter with a pore diameter of 0.1 µm to prepare an under layer film-forming composition.

### Evaluation Examples 1-5 and Comparative Evaluation Example 1 (Evaluation of radiation-sensitive resin composition)

Composition solutions were prepared by homogenously mixing 100 parts (by weight, hereinafter the same) ofpolysiloxanes shown in Table 1, 900 parts of 2-heptanone, the acid generators (B) shown in Table 1, and 8 mol% of 2-phenylbenzimidazole for the total amount of the acid generator (B).

The composition solutions were applied onto a silicon wafer substrate with an under layer film previously formed thereon using a spin coater and pre-baked for 90 seconds on a hot plate at 100°C to form a resist film with a thickness of 1,500 Å.

The under layer film used here was a film with a thickness of 3,000 Å prepared by applying the above-mentioned under layer film forming composition onto a silicon wafer by spin coating and baking on a hot plate for 60 seconds at 180°C and further baking for 120 seconds at 300°C.

The resist films were exposed to an ArF excimer laser (wavelength: 193 nm, NA: 0.78, σ: 0.85) through a photomask using an ArF excimer laser exposure apparatus ("S306C" manufactured by Nikon Corp.), while changing the exposure dose. The films were then heated on a hot plate maintained at 80°C or 95°C for 90 seconds (PEB). The resist films were developed using a 2.38 wt% tetramethylammonium hydroxide aqueous solution at 23°C for 60 seconds, washed with water, and dried to form positive-tone resist patterns.

The line-and-space patterns were evaluated according to the following procedure. The evaluation results are shown in Table 2.

### Evaluation of line-and-space pattern

An optimum exposure dose at which a line-and-space pattern (1L1S) with a line width of 100 nm in a 1:1 line width was formed was taken as sensitivity (1L1S).

The line width (CD) of the line pattern when a 1 line-5 space (IL5S) with a line width of 180 nm was formed at this optimum exposure dose was measured. The larger the value of CD, the better the I-D bias. The acid generators (B) in Table 1 are as follows.

### Acid generators (B)

B-1: Triphenylsulfonium nonafluoro-n-butanesulfonate
B-2: Triphenylsulfonium 2-norbornyl-1, 1,2,2-tetrafluoroethane-1-sulfonate
B-3: Bis(t-butylphenyl)iodonium nonafluoro-n-butanesulfonate
B-4: Bis(cyclohexylsulfonyl)diazomethane
B-5: Triphenylsulfonium 10-camphorsulfonate

**Table 1**

| | Evaluation Example | | | | | Comparative Evaluation Example 1 |
|---|---|---|---|---|---|---|
| | 1 | 2 | 3 | 4 | 5 | |
| Polysiloxane (100 parts) | Example 1 | Example 1 | Example 1 | Example 1 | Example 2 | Comparative Example 1 |
| | | | | B-3 (5) | | |
| Acid generator | B-1 (5) | B-2 (5) | B-3 (5) | B-4 (1.5) | B-3 (5) | B-3 (5) |
| (B) (parts) | B-5 (1.5) | B-5 (1.5) | B-5 (1.5) | B-5 (1.5) | B-5 (1.5) | B-5 (1.5) |
| PEB temperature (°C) | 80 | 80 | 80 | 80 | 80 | 95 |
| Sensitivity (1L1S) (J/m²) | 210 | 230 | 370 | 300 | 400 | 380 |
| CD value (nm) | 133 | 139 | 140 | 138 | 140 | 121 |

### Evaluation Examples 6-7 and Comparative Evaluation Example 2 (evaluation of radiation-sensitive resin composition)

Composition solutions were prepared by homogeneously mixing 100 parts (by weight, hereinafter the same) of polysiloxanes shown in Table 2, 900 parts of 2-heptanone, acid generators (B) shown in Table 2, and 2-phenylbenzimidazole in an amount of 8 mol % of the total amount of the acid generator (B).

Positive-tone resist patterns were formed in the same manner as in Evaluation Examples 1-5 and Comparative Evaluation Example 2.

A substrate for development defect inspection was prepared as follows. The composition solutions were applied to the surface of a silicon wafer substrate with an antireflection film ("ARC29A" manufactured by Nissan Chemical Industries, Ltd.) with a thickness of 77 nm previously formed thereon, in an amount to form a film with a dry thickness of 150 nm. The coating was pre-baked (PB) for 90 seconds at 140°C to obtain resist films. The resist films were exposed to an ArF excimer laser (wavelength: 193 nm, NA: 0.78, σ: 0.85) through a photomask using an ArF excimer laser exposure apparatus ("S306C" manufactured by Nikon Corp.) to form a contact holes with a pore diameter of 110 nm at a pitch of 300 nm. The films were then heated on a hot plate maintained at 140°C for 90 seconds (PEB). Then, the resist film was developed at 23°C for 60 seconds in a 2.38 wt% tetramethylammonium hydroxide aqueous solution, washed with water, and dried to form a substrate for development defect inspection. Application of the composition solutions, PB, PEB, and development were carried out using an inline system ("ACT8" manufactured by Tokyo Electron Ltd.).

Line-and-space patterns, contact hole patterns, and the number of development defects were evaluated according to the procedures described below. The evaluation results are shown in Table 2.

### Evaluation of line-and-space pattern

The cross-sectional configuration of the line patterns of line-and-space (1L1S) patterns with a line width of 100 nm was inspected using a scanning electron microscope.

### Evaluation of contact hole pattern

An optimum exposure dose at which a hole-and-space pattern (1H1S) with a contact hole diameter of 100 nm in a 1:1 line width was formed was taken as the sensitivity (1H1S).

A hole-and-space pattern (1H1S) with a contact hole diameter of 100 nm was formed by irradiating light at an optimum exposure dose while moving the focus to determine a focus range in which the contact hole diameter was 90 nm to 110 nm. The result was regarded as depth of focus (DOF (1H1S)).

### Evaluation of number of development defects

Using a substrate for inspecting development defects and a defect inspector ("KLA2351" manufactured by KLA-Tencor Corp.), the number of development defects was calculated by detecting development defects extracted from the difference obtained by superposing the pixel units and a reference image in an array mode of the defect inspector at a pixel size of 0.16 µm and a ceiling value of 13.

The acid generators (B) in Table 2 are as follows.

### Acid generators (B)

B-1: Triphenylsulfonium nonafluoro-n-butanesulfonate
B-2: Triphenylsulfonium 2-norbornyl-1,1,2,2-tetrafluoroethane-1-sulfonate

**Table 2**

| | Evaluation Example | | Comparative Evaluation Example 2 |
|---|---|---|---|
| | 6 | 7 | |
| Polysiloxane (100 parts) | Example 3 | Example 4 | Comparative Example 1 |
| Acid generator (B) (parts) | B-1 (5) | B-1 (5) | B-1 (5) |
| | B-2(1.5) | B-2(1.5) | B-2(1.5) |
| PEB temperature (°C) | 80 | 80 | 95 |
| Pattern profile | Rectangular | Rectangular | T-top |
| Sensitivity (1H1S) (J/m²) | 450 | 430 | 340 |
| DOF (1H1S) (µm) | 0.4 | 0.4 | 0.2 |
| Development defects (number) | 35 | 40 | 9,550 |

### Example 5 (Preparation of polysiloxane (1-1))

A three-necked flask equipped with a stirrer, a reflux condenser, and a thermometer was charged with 36.3 g of the silane compound (a-1), 41.3 g of a silane compound of the following formula (a-2) (hereinafter referred to as "silane compound (a-2)"), 22.4 g of the silane compound (b-1), 100 g of 4-methyl-2-pentanone, and 23.0 g of a 1.75 wt% aqueous solution of oxalic acid. The mixture was reacted at 60°C for six hours while stirring. The reaction vessel was cooled with ice to terminate the reaction.

34.0 g of distilled water and 47.7 g of triethylamine were added to the reaction solution and stirred at 80°C in a nitrogen stream for six hours, followed by cooling with ice. An aqueous solution of 35.9 g of oxalic acid dissolved in 476.5 g of distilled water was added to the mixture, followed by further stirring. The reaction solution was poured into a separating funnel to remove the water layer. The organic layer was repeatedly washed with ion-exchanged water until the reaction solution became neutral. The solvent was evaporated from the organic layer under reduced pressure to obtain 62.1 g of polysiloxane (1-1). Mw of the obtained polysiloxane (1-1) was 2,140.

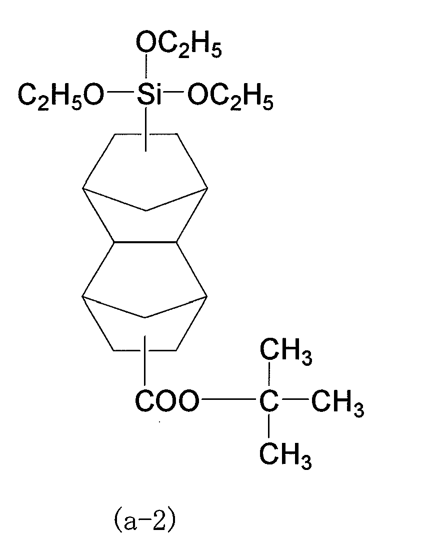

### Example 6 (Preparation of polysiloxane (1-1))

A three-necked flask equipped with a stirrer, a reflux condenser, and a thermometer was charged with 13.2 g of the silane compound (a-1), 24.5 g of a silane compound of the following formula (a-3) (hereinafter referred to as "silane compound (a-3)"), 62.3 g of the silane compound (b-4), 100 g of 4-methyl-2-pentanone, and 16.7 g of a 1.75 wt% aqueous solution of oxalic acid. The mixture was reacted at 60°C for six hours while stirring. The reaction vessel was cooled with ice to terminate the reaction.

24.7 g of distilled water and 34.6 g of triethylamine were added to the reaction solution and stirred at 80°C in a nitrogen stream for six hours, followed by cooling with ice. An aqueous solution of 26.0 g of oxalic acid dissolved in 345.7 g of distilled water was added to the mixture, followed by further stirring. The reaction solution was poured into a separating funnel to remove the water layer. The organic layer was repeatedly washed with ion-exchanged water until the reaction solution became neutral. The solvent was evaporated from the organic layer under reduced pressure to obtain 73.5 g of polysiloxane (1-1). Mw of the obtained polysiloxane (1-1) was 2,060.

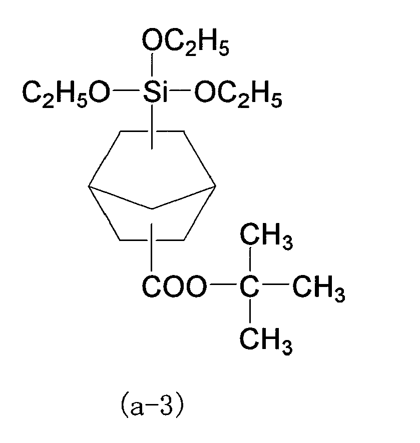

### Comparative Example 2 (Preparation of comparative polysiloxane)

A three-necked flask equipped with a stirrer, a reflux condenser, and a thermometer was charged with 24.6 g of the silane compound (a-3), 30.1 g of the silane compound (b-1), 45.4 g of the silane compound (b-4), 100 g of 4-methyl-2-pentanone, and 16.7 g of a 1.75 wt% aqueous solution of oxalic acid. The mixture was reacted at 60°C for six hours while stirring. The reaction vessel was cooled with ice to terminate the reaction. 24.7 g of distilled water and 34.7 g of triethylamine were added to the reaction solution and stirred at 80°C in a nitrogen stream for six hours, followed by cooling with ice. An aqueous solution of 26.1 g of oxalic acid dissolved in 346.2 g of distilled water was added to the mixture, followed by further stirring. The reaction solution was poured into a separating funnel to remove the water layer. The organic layer was repeatedly washed with ion-exchanged water until the reaction solution became neutral. The solvent was evaporated from the organic layer under reduced pressure to obtain 73.3 g of a polysiloxane. Mw of the polysiloxane was 2,160.

### Evaluation Examples 8-9 and Comparative Evaluation Example 3 (Evaluation of radiation-sensitive resin composition)

Composition solutions were prepared by homogenously mixing 100 parts (by weight, hereinafter the same) of siloxane resins shown in Table 3, 900 parts of 2-heptanone, the acid generators (B) shown in Table 1, and 8 mol% of 2-phenylbenzimidazole for the total amount of the acid generator (B).

The composition solutions were applied onto a silicon wafer substrate with an under layer film previously formed thereon using a spin coater and pre-baked for 90 seconds on a hot plate at 100°C to form a resist film with a thickness of 1,500 Å. The under layer film was prepared in the same manner as in Evaluation Examples 1-5 and Comparative Evaluation Example 1.

The resist films were exposed to an ArF excimer laser (wavelength: 193 nm, NA: 0.78, σ: 0.85) through a photomask using an ArF excimer laser exposure apparatus ("S306C" manufactured by Nikon Corp.), while changing the exposure dose. The films were then heated on a hot plate maintained at 100°C for 90 seconds (PEB). The resist films were developed using a 2.38 wt% tetramethylammonium hydroxide aqueous solution at 23°C for 60 seconds, washed with water, and dried to form a positive-tone resist pattern.

The line-and-space patterns were evaluated according to the following procedure. The evaluation results are shown in Table 3.

### Evaluation of line-and-space pattern

An optimum dose at which a line-and-space pattern (1L1S) with a line width of 90 nm in a 1:1 line width was formed was taken as sensitivity (1L1S).

A line-and-space pattern (1L1S) with a line width of 90 nm was formed by irradiating light at an optimum exposure dose while moving the focus to determine a focus range in which the line width of the line pattern was from 81 nm to 99 nm. The result was regarded as depth of focus (DOF (1L1S)).

The acid generators (B) in Table 3 are as follows.
B-1: Triphenylsulfonium nonafluoro-n-butanesulfonate
B-2: Triphenylsulfonium 2-norbornyl-1,1,2,2-tetrafluoroethane-1-sulfonate

**Table 3**

| | Evaluation Example | | Comparative Evaluation Example 3 |
|---|---|---|---|
| | 8 | 9 | |
| Polysiloxane (100 parts) | Example 5 | Example 6 | Comparative Example 2 |
| Acid generator (B) (parts) | B-1 (5) | B-1 (5) | B-1 (5) |
| | B-2 (1.5) | B-2 (1.5) | B-2 (1.5) |
| PEB temperature (°C) | 100 | 100 | 100 |
| Sensitivity (1L1S) (J/m²) | 210 | 230 | 380 |
| DOF (1L1S) (nm) | 500 | 550 | 250 |

### INDUSTRIAL APPLICABILITY

The silane compound (I) of the present invention is particularly suitable for use as a raw material for synthesizing the polysiloxane (1) of the present invention.

Because it is possible to decrease a PEB temperature and control diffusion of the acid generated by exposure, the radiation-sensitive resin composition of the present invention comprising the polysiloxane (1) as a resin component excels in I-D bias and the process margin of depth of focus (DOF) in both the line-and-space pattern and hole-and-space pattern, and exhibits high sensitivity, excellent pattern profile, resolution, dry etching resistance, and developability.

In addition, the radiation-sensitive resin composition of the present invention comprising the polysiloxane (1-1) containing two types of acid dissociable groups with different acid dissociation properties as a resin component excels in the process margin of depth of focus (DOF) in both the line-and-space pattern and hole-and-space pattern, and exhibits high sensitivity, excellent resolution, dry etching resistance, and developability.

Furthermore, the radiation-sensitive resin composition of the present invention comprising the polysiloxane (1) and polysiloxane (1-1) exhibits excellently balanced afore-mentioned properties.

Therefore, the radiation-sensitive resin composition of the present invention is extremely suitable as a chemically-amplified resist for microfabrication using various radiations such as deep ultraviolet radiation, electron beams, and X-rays.

## Claims

1. A silane compound shown by the following formula (I), 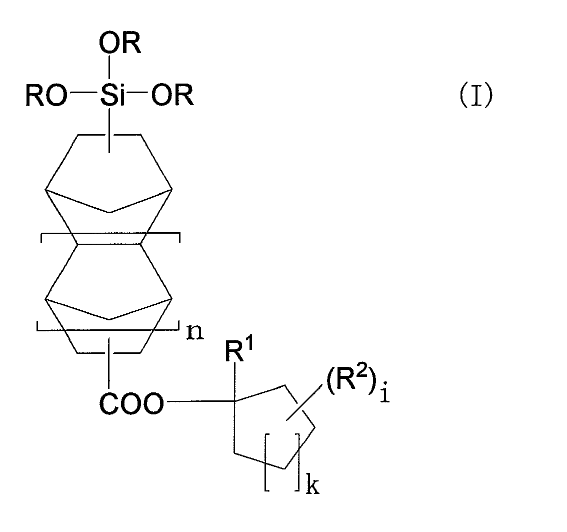 wherein R individually represents a linear, branched, or cyclic alkyl group having 1 to 20 carbon atoms, R¹ and R² individually represents a fluorine atom, a linear or branched alkyl group having 1 to 4 carbon atoms, or a linear or branched fluoroalkyl group having 1 to 4 carbon atoms, n is 0 or 1, k is 1 or 2, and i is an integer of 0 to 8 when k = 1 and an integer of 0 to 10 when k = 2.

2. The silane compound according to claim 1, wherein R in the formula (I) individually represents a methyl group or ethyl group.

3. The silane compound according to claim 1, wherein R¹ represents a methyl group or ethyl group and i is 0 in the formula (I).

4. The silane compound according to claim 1, wherein n is 0 in the formula (I).

5. A polysiloxane having a structural unit shown by the following formula (1) and having a polystyrene-reduced weight average molecular weight determined by gel permeation chromatography (GPC) in a range of 500 to 1,000,000, 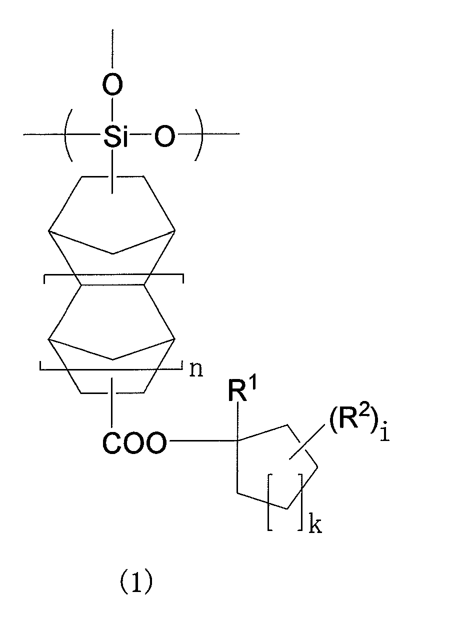 wherein R¹ and R² individually represents a fluorine atom, a linear or branched alkyl group having 1 to 4 carbon atoms, or a linear or branched fluoroalkyl group having 1 to 4 carbon atoms, n is 0 or 1, k is 1 or 2, and i is an integer of 0 to 8 when k = 1 and an integer of 0 to 10 when k = 2.

6. A polysiloxane having a structural unit shown by the following formula (1) and a structural unit shown by the following formula (3), and having a polystyrene-reduced weight average molecular weight determined by gel permeation chromatography (GPC) in a range of 500 to 1,000,000, 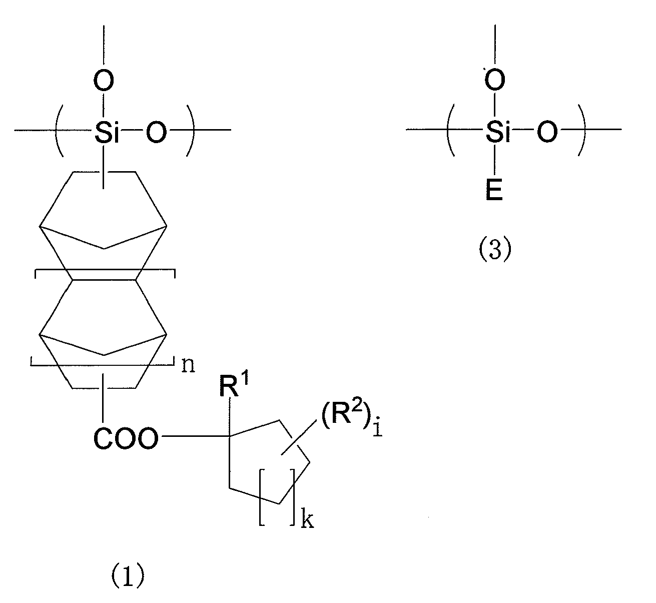 wherein in the formula (1), R¹ and R² individually represents a fluorine atom, a linear or branched alkyl group having 1 to 4 carbon atoms, or a linear or branched fluoroalkyl group having 1 to 4 carbon atoms, n is 0 or 1, k is 1 or 2, and i is an integer of 0 to 8 when k = 1 and an integer of 0 to 10 when k = 2, and in the formula (3), E is a monovalent organic group having a fluorohydrocarbon group.

7. A polysiloxane having a structural unit shown by the following formula (1) and a structural unit shown by the following formula (2) (excluding the structural unit shown by the following formula (1)), and having a polystyrene-reduced weight average molecular weight determined by gel permeation chromatography (GPC) in a range of 500 to 1,000,000, 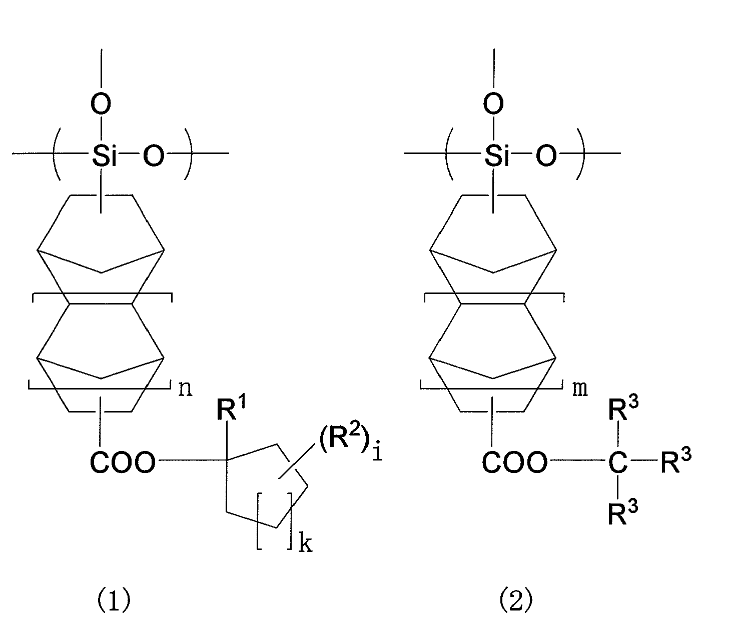 wherein in the formula (1), R¹ and R² individually represents a fluorine atom, a linear or branched alkyl group having 1 to 4 carbon atoms, or a linear or branched fluoroalkyl group having 1 to 4 carbon atoms, n is 0 or 1, k is 1 or 2, and i is an integer of 0 to 8 when k = 1 and an integer of 0 to 10 when k = 2, and in the formula (2), R³ individually represents a linear or branched alkyl group having 1 to 4 carbon atoms or a monovalent alicyclic hydrocarbon group having 4 to 20 carbon atoms or a derivative thereof, or any two of R³s form in combination a divalent alicyclic hydrocarbon group having 4 to 20 carbon atoms or a derivative thereof, with the remaining R³ being a linear or branched alkyl group having 1 to 4 carbon atoms or a monovalent alicyclic hydrocarbon group having 4 to 20 carbon atoms or a derivative thereof, and m is 0 or 1.

8. The polysiloxane according to claim 7, wherein R³ in the formula (2) individually represents a linear or branched alkyl group having 1 to 4 carbon atoms.

9. A polysiloxane having a structural unit shown by the following formula (1), a structural unit shown by the following formula (2) (excluding the structural unit shown by the following formula (1)), and a structural unit shown by the following formula (3), and having a polystyrene-reduced weight average molecular weight determined by gel permeation chromatography (GPC) in a range of 500 to 1,000,000, 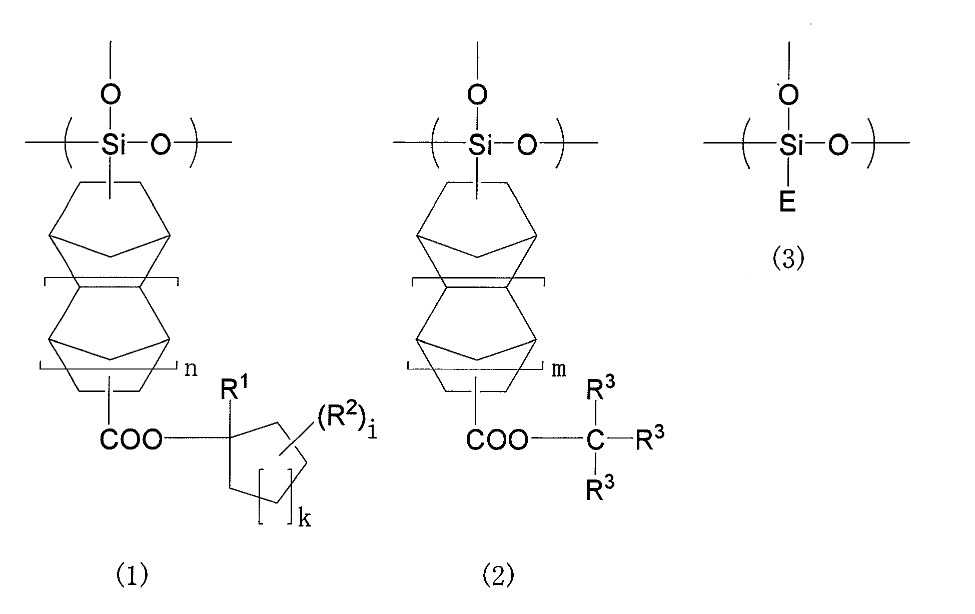 wherein in the formula (1), R¹ and R² individually represents a fluorine atom, a linear or branched alkyl group having 1 to 4 carbon atoms, or a linear or branched fluoroalkyl group having 1 to 4 carbon atoms, n is 0 or 1, k is 1 or 2, and i is an integer of 0 to 8 when k = 1 and an integer of 0 to 10 when k = 2, in the formula (2), R³ individually represents a linear or branched alkyl group having 1 to 4 carbon atoms or a monovalent alicyclic hydrocarbon group having 4 to 20 carbon atoms or a derivative thereof, or any two of R³s form in combination a divalent alicyclic hydrocarbon group having 4 to 20 carbon atoms or a derivative thereof, with the remaining R³ being a linear or branched alkyl group having 1 to 4 carbon atoms or a monovalent alicyclic hydrocarbon group having 4 to 20 carbon atoms or a derivative thereof, and m is 0 or 1, and in the formula (3), E is a monovalent organic group having a fluorohydrocarbon group.

10. A radiation-sensitive resin composition comprising (A) the polysiloxane according to claim 5 and (B) a photoacid generator.

11. A radiation-sensitive resin composition comprising (A) the polysiloxane according to claim 6 and (B) a photoacid generator.

12. A radiation-sensitive resin composition comprising (A) the polysiloxane according to claim 7 and (B) a photoacid generator.

13. A radiation-sensitive resin composition comprising (A) the polysiloxane according to claim 8 and (B) a photoacid generator.

14. A radiation-sensitive resin composition comprising (A) the polysiloxane according to claim 9 and (B) a photoacid generator.

15. The radiation-sensitive resin composition according to claim 10, wherein (B) the photoacid generator is a compound generating a sulfonic acid by exposure to radiation.

16. The radiation-sensitive resin composition according to claim 11, wherein (B) the photoacid generator is a compound generating a sulfonic acid by exposure to radiation.

17. The radiation-sensitive resin composition according to claim 12, wherein (B) the photoacid generator is a compound generating a sulfonic acid by exposure to radiation.

18. The radiation-sensitive resin composition according to claim 13, wherein (B) the photoacid generator is a compound generating a sulfonic acid by exposure to radiation.

19. The radiation-sensitive resin composition according to claim 14, wherein (B) the photoacid generator is a compound generating a sulfonic acid by exposure to radiation.
